# EUROPEAN PATENT APPLICATION

(11) **EP 4 625 133 A1**
(43) Date of publication of application: **01.10.2025**
(21) Application number: 25166530.3
(22) Date of filing: 27.03.2025
(51) Int. Cl.: G06F 3/06

(54) **DATA READ METHOD, DATA WRITE METHOD, APPARATUS, AND SYSTEM**

(30) Priority: 27.03.2024 CN 202410361646
(71) Applicant: Huawei Technologies Co., Ltd., Shenzhen, Guangdong 518129 (CN)
(72) Inventor: DENG, Renbin, Shenzhen, 518129 (CN); CHEN, Tao, Shenzhen, 518129 (CN)
(74) Representative: Gill Jennings & Every LLP

(57) **Abstract**

This application relates to a data read method, a data write method, an apparatus, and a system. **In** this method, consecutive data blocks are selected for merge compression, so that more data blocks appear in a merged and compressed data block during data reading, and especially for a sequential read/write scenario, a plurality of blocks that need to be read at the same time are more likely to appear in a same merged and compressed block. Read requests are merged, to reduce a quantity of read operations, and reduce a disk read amplification ratio and a decompression calculation amount in a read procedure. **In** addition, whether to perform read, decompression, and re-merge compression is determined based on validity of a data block by using a garbage collection procedure, to reduce read amplification and decompression calculation amount amplification in the garbage collection procedure. During data migration, re-merge compression is performed on adjacent data blocks, to maintain a compression ratio and reduce redundant data.

## Description

### TECHNICAL FIELD

This application relates to the field of storage technologies, and in particular, to a data read method, a data write method, an apparatus, and a system.

### BACKGROUND

Data compression is a method for reducing redundant information without losing valid information of data. Through data compression, storage space used when the data is stored can be effectively saved, and an amount of data that can be stored in a data storage system increases.

Merge compression (merge compression) is a common data compression manner. The merge compression is a manner of first merging a plurality of data blocks (blocks) into a merged data block, and then compressing the merged data block. Generally, when the merge compression is performed, a larger quantity of data blocks participating in merging indicates more redundant data to be reduced and a higher data reduction ratio.

Although the merge compression can reduce redundant information in a single to-be-merged data block, to save storage space more effectively, data read performance may be poor after the merge compression is used. Therefore, how to resolve a problem of poor data read performance caused by the merge compression needs to be considered currently.

### SUMMARY

Embodiments of this application provide a data read method, a data write method, an apparatus, and a system, to improve performance of a data storage system.

**According to a first aspect,** a data read method is provided. The method may be performed by a control apparatus of a storage system. The method includes: obtaining a second read request, where the second read request is determined based on P first read requests, the P first read requests are for reading P first data blocks, and P is a positive integer; performing a read operation based on the second read request, to obtain Q second data blocks, where one of the Q second data blocks is obtained by performing merge compression on at least one first data block, and the P first data blocks are a part or all of first data blocks for obtaining the Q second data blocks; and obtaining the P first data blocks based on data obtained by decompressing the Q second data blocks.

In this implementation, after at least one first data block is merged and compressed into a second data block for storage, if the P first data blocks are expected to be read, the second read request may be determined based on the P first read requests corresponding to the P first data blocks. In this case, the Q second data blocks may be obtained by performing the read operation based on the second read request, and the P first data blocks may be obtained based on the data obtained by decompressing the Q second data blocks. In a related technology, although a plurality of data blocks are compressed into one compressed block, a read operation still needs to be performed for each read request during data reading. However, in this embodiment of this application, the first read requests are merged, so that a quantity of read operations is reduced, and data read performance is improved. In addition, if two first data blocks are merged and compressed into one second data block for storage, in an implementation of the related technology, when the two first data blocks are read, two corresponding read requests are separately executed, and an execution result is that the second data block is read twice. In addition, decompression operations are respectively performed on the two same second data blocks to respectively obtain the two first data blocks. This is equivalent to that, to read the two first data blocks, two decompression operations need to be performed on one second data block. However, in this implementation of this embodiment of this application, the first read requests are merged, and only one time of reading and one decompression operation need to be performed on each second data block. This reduces the quantity of read operations, and reduces a calculation amount required for decompression.

In a possible implementation, before the determining a second read request, the control apparatus may receive first signaling from a client, where the first signaling is for requesting to obtain a third data block; determine the P first data blocks based on the first signaling, where the P first data blocks are data blocks associated with the third data block; and determine the P first read requests based on the P first data blocks.

In this implementation, a data block that may be read by the client, namely, the P first data blocks associated with the third data block, may be determined based on a third data block actually read by the client, and the P first data blocks are read. In this way, effect of triggering, by using one request, reading of a plurality of data blocks can be achieved, and data obtaining efficiency is improved.

In a possible implementation, after the P first data blocks are read, the P first data blocks may be stored in a memory. When second signaling is received from the client, and the second signaling is for requesting to obtain a fourth data block, the fourth data block may be obtained from the memory, and the fourth data block is sent to the client. The fourth data block includes a part or all of the P first data blocks.

In this implementation, the read P first data blocks may be stored in the memory for caching. When the client needs to read the fourth data block in the P first data blocks, the client does not need to perform a disk read operation. The disk read operation is an operation of reading data stored in a storage device (for example, a hard disk) into a memory. In comparison with a manner of reading data from the memory and sending the data to the client after the disk read operation is completed, in this implementation of this embodiment of this application, the data can be directly read from the memory and sent to the client. This reduces a data obtaining delay of the client and improves data obtaining efficiency.

In a possible implementation, first identifiers of the P first data blocks are consecutive, and each first identifier identifies one first data block. The manner of merging read requests to read data provided in this embodiment of this application may be applied to a consecutive data read scenario. In the consecutive data read scenario, a sequence of data blocks is usually consecutive. Compared with inconsecutive data blocks, consecutive data blocks have a higher probability of being compressed into a same second data block, so that a quantity of read operations can be more effectively reduced, and data read performance can be improved.

In a possible implementation, that the first identifiers of the P first data blocks are consecutive may include: Storage addresses of the P first data blocks are consecutive; and/or sequence numbers of the P first data blocks in a file are consecutive, the file includes the P first data blocks, and the sequence number indicates a location of one first data block in the file. For example, if a large file is divided into a plurality of data blocks, the plurality of data blocks may be numbered in sequence, and one sequence number is a number corresponding to one data block.

In a possible implementation, second identifiers of the P first data blocks may be obtained based on the first identifiers included in the P first read requests, and the P first read requests are merged based on the second identifiers of the P first data blocks, to obtain the second read request. Each first identifier identifies one first data block, and a second identifier of one of the P first data blocks indicates a location of the first data block.

In this implementation, the P first read requests may be merged based on locations of the first data blocks. For example, if the location of the first data block is a location in the storage unit, and first data blocks at a same location are merged and compressed into a same second data block, first read requests for reading these first data blocks may be merged, to obtain these first data blocks by performing one read operation and one decompression operation, so that a quantity of read operations and decompression operations is reduced, and data read performance is improved. Alternatively, the location of the first data block is a storage unit in which the first data block is located. If to-be-read first data blocks are stored in a same storage unit, the P first read requests may be merged based on the storage unit. When a read operation is performed, metadata information of the storage unit needs to be queried to obtain a to-be-read physical location. In this case, after these first read requests are merged, for first data blocks stored in a same storage unit, the metadata information of the storage unit needs to be queried only once. This reduces a quantity of times of querying the metadata information and improves data read performance.

In a possible implementation, the second identifier of the first data block includes a plurality of implementations, for example, includes one or more of the following implementations.

In an implementation of the second identifier of the first data block, the second identifier includes a third identifier, and the third identifier indicates a storage unit in which a second data block to which the first data block belongs is located. In this case, the P first read requests may be merged based on storage units in which second data blocks to which the P first data blocks respectively belong are located. For example, if first read requests corresponding to a same storage unit are merged, for first read requests corresponding to first data blocks stored in a same storage unit, metadata information of the storage unit needs to be queried only once. This reduces a quantity of times of querying the metadata information and improves data read performance. In addition, when two second data blocks are adjacent in a same storage unit, the two second data blocks may be read by using one read operation. This reduces a quantity of read operations and improves data read performance. A storage unit corresponding to one first read request is a storage unit configured to store a second data block that the first read request requests to read.

In another implementation of the second identifier of the first data block, the second identifier includes first information, and the first information indicates a location of the second data block to which the first data block belongs in the storage unit. In this case, the P first read requests may be merged based on locations of the second data blocks to which the P first data blocks respectively belong in the storage units. For example, if locations of first data blocks that need to be read in a storage unit are the same, in other words, these first data blocks are merged and compressed into a same second data block, and first read requests corresponding to the first data blocks are merged, these first data blocks may be obtained by reading the second data block once. This reduces a quantity of read operations and improves data read performance.

In another implementation of the second identifier of the first data block, the second identifier includes second information, and the second information indicates a location of the first data block in a fifth data block to which the first data block belongs. The fifth data block is obtained by decompressing the second data block to which the first data block belongs, in other words, the second data block to which the first data block belongs is obtained by compressing the fifth data block. In this case, when the P first read requests are merged, the location of the first data block in the fifth data block to which the first data block belongs may be further considered. For example, when first data blocks requested to be read by using two first read requests belong to a same fifth data block, and locations of the two first data blocks in the fifth data block (in other words, the two first data blocks correspond to a segment of data in the fifth data block) are also the same, the two first read requests are merged, in other words, first read requests for reading a same first data block are merged. In this case, data read requirements of a plurality of first read requests can be met by performing only one read operation. This reduces a quantity of read operations and improves data read performance.

In a possible implementation, the merging the P first read requests based on the second identifiers of the P first data blocks, to obtain the second read request includes the following steps: determining, based on the second identifiers of the P first data blocks, that the P first data blocks are included in the Q second data blocks, where one of the Q second data blocks includes a part of the P first data blocks; merging first read requests corresponding to first data blocks that belong to a same second data block, to obtain Q third read requests; determining, based on the second identifiers of the P first data blocks, that the Q second data blocks are stored in a same storage unit; and merging the Q third read requests to obtain the second read request.

In this implementation, to-be-read first data blocks are merged and compressed into a same second data block. In this case, first read requests for reading these first data blocks may be merged, to obtain these first data blocks by using one read operation. This reduces a quantity of read operations and improves data read performance. In addition, third read requests corresponding to second data blocks stored in a same storage unit can be merged. In this case, for the third read requests corresponding to the second data blocks stored in the same storage unit, metadata information of the storage unit needs to be queried only once. This reduces a quantity of times of querying the metadata information and improves data read performance. In addition, when two second data blocks are consecutively stored in a same storage unit, the two second data blocks may be read by using one read operation. This can also reduce the quantity of read operations and improve the data read performance.

In a possible implementation, when the Q second data blocks are decompressed, the Q second data blocks may be first decompressed to obtain Q fifth data blocks, where one of the Q fifth data blocks is obtained by concatenating at least one first data block. Then third information of the Q fifth data blocks is obtained, where one piece of third information indicates a location of each of at least one first data block corresponding to one fifth data block in the fifth data block. Further, the P first data blocks are obtained from the Q fifth data blocks based on the third information of the Q fifth data blocks. In this implementation, a location of a required first data block in the fifth data block may be determined in an auxiliary manner based on the third information, to successfully obtain the required first data block from the second data block obtained through merge compression.

In a possible implementation, the piece of third information includes or indicates a total quantity of first data blocks included in the fifth data block and a length of the first data block included in the fifth data block. In this way, a location of a first data block in the fifth data block may be determined by using a sequence number and a data length that correspond to the first data block, to obtain the corresponding first data block from the fifth data block.

In a possible implementation, a first data block may be further written into the storage unit, and a write process includes: obtaining N first data blocks, where first identifiers of the N first data blocks are consecutive, each first identifier identifies one first data block, and N is a positive integer; performing merge compression on the N first data blocks based on the first identifiers of the N first data blocks, to obtain a second data block; and storing the second data block in a first storage unit.

In this implementation, when the first data blocks are stored, merge compression is performed on a plurality of first data blocks whose first identifiers are consecutive, to reduce redundant data and improve storage space utilization. In addition, corresponding first data blocks in an obtained second data block are also consecutive, and for consecutive first data blocks, a probability that these consecutive first data blocks are located in a same second data block is higher during data reading. Therefore, after first read requests for reading these first data blocks are merged, a quantity of read operations that need to be performed is smaller, and correspondingly, a quantity of second read requests is smaller. This can reduce a quantity of times of querying metadata information of the storage unit and improve data read efficiency. In a manner of performing merge compression on consecutive data blocks, a quantity of second data blocks obtained by performing merge compression on these first data blocks is smaller. This can reduce a quantity of decompression times during data reading and a calculation amount required for decompression.

In a possible implementation, the obtaining N first data blocks includes: receiving at least one data packet from the client, where each of the at least one data packet includes one or more sixth data blocks, and first identifiers of the one or more sixth data blocks are consecutive; storing, in the memory, the one or more sixth data blocks included in each of the at least one data packet; aggregating a plurality of sixth data blocks stored in the memory, to obtain at least one seventh data block; and slicing the at least one seventh data block to obtain the N first data blocks.

In this implementation, a plurality of sixth data blocks with consecutive first identifiers may be cached in the memory, and then the plurality of sixth data blocks are aggregated and sliced, to obtain first data blocks with consecutive first identifiers. In this way, a large quantity of write requests for the first data blocks can be generated in batches. This helps perform merge compression on the consecutive first data blocks and improves storage space utilization.

In a possible implementation, the performing merge compression on the N first data blocks based on the first identifiers of the N first data blocks, to obtain a second data block includes: concatenating the N first data blocks in a sequence of the first identifiers of the N first data blocks, to obtain a fifth data block; and compressing the fifth data block to obtain the second data block.

In this implementation, the first data blocks may be sequentially concatenated in a sequence of the first identifiers, to achieve effect of performing merge compression on consecutive first data blocks.

In a possible implementation, N is less than or equal to a first threshold; and/or a sum of lengths of the N first data blocks is less than or equal to a second threshold. This avoids a case in which if a data amount of a single second data block is excessively large, a larger data read amount and a larger decompression calculation amount are needed when the single first data block is read. In this embodiment of this application, a quantity of first data blocks corresponding to each second data block may be restricted, to alleviate a problem of a large data read amount and a large decompression amount caused by the excessively large data amount of the single second data block during obtaining of a part of first data blocks. This helps improve performance during data reading and reduce a decompression calculation amount.

In a possible implementation, the compressing the fifth data block to obtain the second data block includes: obtaining the second data block based on the fifth data block and third information, where the third information indicates locations of the N first data blocks in the fifth data block.

In this implementation, the second data block may include the third information indicating the locations of the first data blocks. In this case, during decompression, the location of the required first data block in the fifth data block may be determined in the auxiliary manner based on the third information, to successfully obtain the required first data block from the second data block obtained through merge compression.

In a possible implementation, the third information includes a total quantity of the N first data blocks and a length of each of the N first data blocks.

In a possible implementation, after a write operation is performed on the second data block, second identifiers of the N first data blocks are further stored. Each second identifier indicates a location of one first data block. A second identifier of one of the N first data blocks includes one or more of the following: a third identifier, indicating the storage unit in which the second data block to which the first data block belongs is located; first information, indicating a location of the second data block to which the first data block belongs in the storage unit; and second information, indicating a location of the first data block in the fifth data block to which the first data block belongs.

In this implementation, a second identifier indicating a location of each first data block may be stored. This helps quickly locate each first data block during data reading and improve data read efficiency.

In a possible implementation, when it is determined that a value of a first parameter of a second storage unit is greater than a third threshold, the second storage unit is released. The first parameter indicates a quantity of invalid first data blocks stored in the second storage unit, and the invalid first data block is a data block that is indicated by a corresponding first identifier and whose data is rewritten or deleted. In this case, storage space of a storage unit with a large quantity of invalid first data blocks may be released, to store a new data block, so as to improve storage space utilization.

In a possible implementation, that the second storage unit is released includes: storing, in a third storage unit, a second data block whose corresponding first data blocks are all valid; and storing, in the third storage unit, a valid first data block in a second data block whose corresponding first data blocks are partially invalid, where the valid first data block is a data block other than the invalid first data block.

In this implementation, when the second storage unit is released, the valid first data blocks are stored in the third storage unit, to avoid a data loss.

In a possible implementation, the storing, in the third storage unit, a valid first data block in a second data block whose corresponding first data blocks are partially invalid includes: performing merge compression on the valid first data block based on an order of a first identifier, to obtain at least one second data block; and storing the at least one second data block in the third storage unit.

In this implementation, when the valid first data blocks are stored in the third storage unit, re-merge compression is performed on the valid first data blocks, to maintain a compression ratio (compression ratio) of the data block, reduce redundant data, and improve storage space utilization.

In a possible implementation, the first parameter includes one or more of the following: the quantity of invalid first data blocks; a ratio of the quantity of invalid first data blocks to a total quantity of first data blocks stored in the second storage unit; a sum of lengths of the invalid first data blocks, where the length is a length occupied by the invalid first data block in a corresponding second data block; or a ratio of a sum of lengths of the invalid first data blocks to a total length of data stored in the second storage unit, where the length is a length occupied by the invalid first data block in a corresponding second data block.

In a possible implementation, a length occupied by one first data block in a second data block to which the first data block belongs is determined based on a total length of the second data block and a quantity of first data blocks corresponding to the second data block. For example, a length occupied by one first data block in a second data block to which the first data block belongs is a ratio of a total length of the second data block to a quantity of first data blocks corresponding to the second data block.

**According to a second aspect,** a data write method is provided. The method may be performed by a control apparatus of a storage system. The method includes: obtaining N first data blocks, where first identifiers of the N first data blocks are consecutive, one of the first identifiers identifies one first data block, and N is a positive integer; performing merge compression on the N first data blocks based on the first identifiers of the N first data blocks, to obtain a second data block; and storing the second data block in a first storage unit.

In a possible implementation, the first identifier includes: a storage address of the first data block; and/or a sequence number of the first data block in a file, where the file includes the N first data blocks, and the sequence number of the first data block in the file indicates a location of the first data block in the file.

In a possible implementation, the obtaining N first data blocks includes: receiving at least one data packet from a client, where each of the at least one data packet includes one or more sixth data blocks, and first identifiers of the one or more sixth data blocks are consecutive; storing, in a memory, the one or more sixth data blocks included in each of the at least one data packet; aggregating a plurality of sixth data blocks stored in the memory, to obtain at least one seventh data block; and slicing the at least one seventh data block to obtain the N first data blocks.

In a possible implementation, the performing merge compression on the N first data blocks based on the first identifiers of the N first data blocks, to obtain a second data block includes: concatenating the N first data blocks in a sequence of the first identifiers of the N first data blocks, to obtain a fifth data block; and compressing the fifth data block to obtain the second data block.

In a possible implementation, N is less than or equal to a first threshold; and/or a sum of lengths of the N first data blocks is less than or equal to a second threshold.

In a possible implementation, the compressing the fifth data block to obtain the second data block includes: obtaining the second data block based on the fifth data block and third information, where the third information indicates locations of the N first data blocks in the fifth data block.

In a possible implementation, the third information includes a total quantity of the N first data blocks and a length of each of the N first data blocks.

In a possible implementation, after a write operation is performed on the second data block, the method further includes: storing second identifiers of the N first data blocks, where each second identifier indicates a location of one first data block, and a second identifier of one of the N first data blocks includes one or more of the following: a third identifier, indicating the storage unit in which the second data block to which the first data block belongs is located; first information, indicating a location of the second data block to which the first data block belongs in the storage unit; and second information, indicating a location of the first data block in the fifth data block to which the first data block belongs.

In a possible implementation, the method further includes: determining that a value of a first parameter of a second storage unit is greater than a third threshold, where the first parameter indicates a quantity of invalid first data blocks stored in the second storage unit, and the invalid first data block is a data block that is indicated by a corresponding first identifier and whose data is rewritten or deleted; and releasing the second storage unit.

In a possible implementation, the releasing the second storage unit further includes: storing, in a third storage unit, a second data block whose corresponding first data blocks are all valid; and storing, in the third storage unit, a valid first data block in a second data block whose corresponding first data blocks are partially invalid, where the valid first data block is a data block other than the invalid first data block.

In a possible implementation, the storing, in the third storage unit, a valid first data block in a second data block whose corresponding first data blocks are partially invalid includes: performing merge compression on the valid first data block based on an order of a first identifier, to obtain at least one second data block; and storing the at least one second data block in the third storage unit.

In a possible implementation, the first parameter includes one or more of the following: the quantity of invalid first data blocks; a ratio of the quantity of invalid first data blocks to a total quantity of first data blocks stored in the second storage unit; a sum of lengths of the invalid first data blocks, where the length is a length occupied by the invalid first data block in a corresponding second data block; or a ratio of a sum of lengths of the invalid first data blocks to a total length of data stored in the second storage unit, where the length is a length occupied by the invalid first data block in a corresponding second data block.

In a possible implementation, a length occupied by one first data block in a second data block to which the first data block belongs is determined based on a total length of the second data block and a quantity of first data blocks corresponding to the second data block. For example, a length occupied by one first data block in a second data block to which the first data block belongs is a ratio of a total length of the second data block to a quantity of first data blocks corresponding to the second data block.

In a possible implementation, the method further includes: determining a second read request, where the second read request is determined based on P first read requests, the P first read requests are for reading P first data blocks, and P is a positive integer; performing a read operation based on the second read request, to obtain Q second data blocks, where one of the Q second data blocks is obtained by performing merge compression on at least one first data block, and the P first data blocks are a part or all of first data blocks for obtaining the Q second data blocks; and obtaining the P first data blocks based on data obtained by decompressing the Q second data blocks.

In a possible implementation, before the determining a second read request, the control apparatus may receive first signaling from the client, where the first signaling is for requesting to obtain a third data block; determine the P first data blocks based on the first signaling, where the P first data blocks are data blocks associated with the third data block; and determine the P first read requests based on the P first data blocks.

In a possible implementation, after the P first data blocks are read, the P first data blocks may be stored in the memory. Second signaling is received from the client, where the second signaling is for requesting to obtain a fourth data block, and the fourth data block includes a part or all of the P first data blocks. The fourth data block is obtained from the memory, and the fourth data block is sent to the client.

In a possible implementation, first identifiers of the P first data blocks are consecutive, and each first identifier identifies one first data block.

In a possible implementation, second identifiers of the P first data blocks may be obtained based on the first identifiers included in the P first read requests, where each first identifier identifies one first data block, and a second identifier of one of the P first data blocks indicates a location of the first data block. In addition, the P first read requests are merged based on the second identifiers of the P first data blocks, to obtain the second read request.

In a possible implementation, the second identifier of the first data block includes a plurality of implementations, for example, includes the following implementations or a combination of the following implementations:
In an implementation, the second identifier includes a third identifier, and the third identifier indicates a storage unit in which a second data block to which the first data block belongs is located.

In another implementation, the second identifier includes first information, and the first information indicates a location of the second data block to which the first data block belongs in the storage unit.

In another implementation, the second identifier includes second information, and the second information indicates a location of the first data block in a fifth data block to which the first data block belongs.

In a possible implementation, that the P first read requests are merged based on the second identifiers of the P first data blocks, to obtain the second read request includes the following steps: determining, based on the second identifiers of the P first data blocks, that the P first data blocks are included in the Q second data blocks, where one of the Q second data blocks includes a part of the P first data blocks; merging first read requests corresponding to first data blocks that belong to a same second data block, to obtain Q third read requests; determining, based on the second identifiers of the P first data blocks, that the Q second data blocks are stored in a same storage unit; and merging the Q third read requests to obtain the second read request.

In a possible implementation, a second compressed block is obtained by compressing a plurality of concatenated first data blocks. In this case, when the Q second data blocks are decompressed, the Q second data blocks may be first decompressed to obtain Q fifth data blocks, where one of the Q fifth data blocks is obtained by concatenating at least one first data block. Then third information of the Q fifth data blocks is obtained, where one piece of third information indicates a location of each of at least one first data block corresponding to one fifth data block in the fifth data block. Further, the P first data blocks are obtained from the Q fifth data blocks based on the third information of the Q fifth data blocks.

In a possible implementation, the piece of third information includes a total quantity of first data blocks included in the fifth data block and a length of each first data block included in the fifth data block.

For technical effects brought by the second aspect or the optional implementations, refer to the descriptions of the technical effects of the first aspect or the corresponding implementations.

According to a third aspect, an embodiment of this application further provides a control apparatus. The control apparatus has a function of implementing the method embodiment in the first aspect or the second aspect. For beneficial effects, refer to the descriptions of the first aspect or the second aspect. Details are not described herein again. The implementing function of the control apparatus may be implemented by hardware, or may be implemented by hardware executing corresponding software. The hardware or the software includes one or more modules corresponding to the function.

In a possible implementation, the control apparatus includes a request merging module, a data read module, and a decompression module. These modules may perform corresponding functions in the method example in the first aspect or the second aspect. For details, refer to the detailed descriptions in the method example. Details are not described herein again.

For example, the request merging module is configured to obtain a second read request. The second read request is determined based on P first read requests, the P first read requests are for reading P first data blocks, and P is a positive integer. The data read module is configured to perform a read operation based on the second read request, to obtain Q second data blocks. One of the Q second data blocks is obtained by performing merge compression on at least one first data block, and the P first data blocks are a part or all of first data blocks for obtaining the Q second data blocks. The decompression module is configured to decompress the Q second data blocks to obtain the P first data blocks.

By using the apparatus, after the at least one first data block is merged and compressed into the second data block for storage, if the P first data blocks are expected to be read, the second read request may be determined based on the P first read requests corresponding to the P first data blocks, and the Q second data blocks including the P first data blocks may be obtained by performing the read operation based on the second read request. However, in a related technology, although a plurality of data blocks are compressed into one compressed block, a read operation still needs to be performed for each read request during data reading. In this implementation of this embodiment of this application, the first read requests are merged, so that a quantity of read operations is reduced, and data read performance is improved. In addition, if two first data blocks are merged and compressed into one second data block for storage, in an implementation of the related technology, when the two data blocks are read, two corresponding read requests are separately executed, and the second data block is read twice. In addition, decompression operations are respectively performed to obtain the two first data blocks. This is equivalent to that, to read the two data blocks, two decompression operations need to be performed on one second data block. However, in this implementation of this embodiment of this application, the first read requests are merged, and only one time of reading and one decompression operation need to be performed on each second data block. This reduces the quantity of read operations, and reduces a calculation amount required for decompression.

In a possible implementation, the control apparatus includes a request obtaining module, a merge compression module, and a data write module. These modules may perform corresponding functions in the method example in the first aspect or the second aspect. For details, refer to the detailed descriptions in the method example. Details are not described herein again.

For example, the request obtaining module is configured to obtain N first data blocks. First identifiers of the N first data blocks are consecutive, each first identifier identifies one first data block, and N is a positive integer. The merge compression module is configured to perform merge compression on the N first data blocks based on the first identifiers of the N first data blocks, to obtain a second data block. The data write module is configured to store the second data block in a first storage unit.

By using the apparatus, when the first data blocks are stored, merge compression is performed on a plurality of first data blocks whose first identifiers are consecutive, to reduce redundant data and improve storage space utilization. In addition, corresponding first data blocks in an obtained second data block are also consecutive, and for consecutive first data blocks, a probability that these first data blocks are located in a same second data block is higher during data reading. Therefore, a quantity of second data blocks that need to be read by using a second read request obtained through merging is smaller, and correspondingly, a quantity of read operations that need to be performed is smaller. In a manner of performing merge compression on consecutive data blocks, a quantity of second data blocks obtained by performing merge compression on these first data blocks is smaller. This can reduce a quantity of decompression times during data reading and a calculation amount required for decompression.

According to a fourth aspect, this application further provides a computer device. The computer device includes a processor and a storage, and may further include a communication interface. The processor executes program instructions in the storage to perform the method provided in any one of the first aspect or the possible implementations of the first aspect, or the processor executes the program instructions in the storage to perform the method provided in any one of the second aspect or the possible implementations of the second aspect. The storage is coupled to the processor and the memory stores program instructions and data that are necessary in a method process of reading data or writing data. The communication interface is configured to communicate with another device, for example, receive signaling sent by a client and return finally read data to the client, receive a data packet sent by the client, or communicate with a storage unit to read data or write data.

According to a fifth aspect, this application provides a computer system. The computer system includes at least one computer device, and each computing device includes a storage and a processor. The processor of the at least one computer device is configured to access code in the storage to perform the method provided in any one of the first aspect or the possible implementations of the first aspect, or perform the method provided in any one of the second aspect or the possible implementations of the second aspect.

According to a sixth aspect, this application provides a storage apparatus. The storage apparatus includes a control apparatus and a storage array. The storage array is configured to store data. The controller is configured to perform the method provided in any one of the first aspect or the possible implementations of the first aspect, or perform the method provided in any one of the second aspect or the possible implementations of the second aspect.

According to a seventh aspect, this application provides a storage system. The storage system includes a controller and at least one storage device. The storage device is configured to store data. The controller is configured to perform the method provided in any one of the first aspect or the possible implementations of the first aspect, or perform the method provided in any one of the second aspect or the possible implementations of the second aspect.

According to an eighth aspect, this application provides a computer-readable storage medium. The computer-readable storage medium stores computer-executable instructions. The computer executable instructions are for enabling a computer device to perform the method provided in any one of the first aspect or the possible implementations of the first aspect, or perform the method provided in any one of the second aspect or the possible implementations of the second aspect. The storage medium includes but is not limited to a volatile memory, for example, a random access memory, or a non-volatile memory, for example, a flash memory, a hard disk drive (HDD), or a solid state drive (SSD).

According to a ninth aspect, this application provides a computer program product. The computer program product includes computer instructions. When the computer instructions are executed by a computer device, the computer device performs the method provided in any one of the first aspect or the possible implementations of the first aspect, or performs the method provided in any one of the second aspect or the possible implementations of the second aspect. The computer program product may be a software installation package. When the method provided in any one of the first aspect or the possible implementations of the first aspect needs to be used, the computer program product may be downloaded and executed on the computer device.

According to a tenth aspect, this application further provides a chip system. The chip system includes a processor and an interface. The processor is configured to invoke instructions from the interface and run the instructions, so that the chip system implements the methods in the foregoing aspects.

For beneficial effects of the third aspect to the seventh aspect and the implementations of the third aspect to the seventh aspect, refer to the descriptions of the beneficial effects of the first aspect and any implementation of the first aspect.

### BRIEF DESCRIPTION OF DRAWINGS

FIG. 1 is a diagram of an architecture of a possible application system in a solution according to an embodiment of this application;
FIG. 2 is a schematic flowchart of a data write method according to an embodiment of this application;
FIG. 3 is a diagram of obtaining N first data blocks according to an embodiment of this application;
FIG. 4 is a schematic flowchart of a data write process according to an embodiment of this application;
FIG. 5 is a schematic flowchart of a data read method according to an embodiment of this application;
FIG. 6 is an example diagram of a merging process according to an embodiment of this application;
FIG. 7 is a schematic flowchart of a garbage collection process according to an embodiment of this application;
FIG. 8 is an example diagram of a garbage collection process according to an embodiment of this application;
FIG. 9 is a diagram of a structure of a control apparatus according to an embodiment of this application;
FIG. 10 is a diagram of a structure of another control apparatus according to an embodiment of this application; and
FIG. 11 is a diagram of another structure of a control apparatus according to an embodiment of this application.

### DESCRIPTION OF EMBODIMENTS

To make objectives, technical solutions, and advantages of embodiments of this application clearer, the following further describes embodiments of this application in detail with reference to the accompanying drawings.

In embodiments of this application, unless otherwise specified, a quantity of nouns represents "a singular noun or plural nouns", that is, "one or more". "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. For example, A/B indicates A or B. "At least one of the following items (pieces)" or an expression similar thereto means any combination of these items, including a singular item (piece) or any combination of plural items (pieces). For example, at least one item (piece) of a, b, or c indicates a, b, c, a and b, a and c, b and c, or a, b, and c, where a, b, and c may be singular or plural.

Ordinal numbers such as "first" and "second" mentioned in embodiments of this application are for distinguishing between a plurality of objects, but are not for limiting sizes, content, a sequence, a time sequence, priorities, importance, or the like of the plurality of objects. For example, a first data block and a third data block may be a same data block, or may be different data blocks. In addition, step numbers in embodiments described in this application are merely intended to distinguish between different steps, but are not intended to limit a sequence of the steps.

Before the specific solutions provided in embodiments of this application are described, a part of terms or concepts in this application are explained and described, to facilitate understanding by a person skilled in the art.

### (1) Sequential write and sequential read

The sequential write and sequential read, as the name suggests, is to centralize to-be-processed data in a queue and perform continuous write or read at an optimal speed. Generally, an ideal sequential read/write speed may be achieved when a large file is read/written. In summary, sequential read/write means that a solid state drive works based on a data sequence in a data read or write process, features read or write continuity, and specifically indicates that read/write time is short and continuous, and read/write data is large and centralized.

### (2) Disk read amplification ratio

The disk read amplification ratio is a ratio of an amount of data actually read to an amount of data requested to be read in a data read process. For example, the amount of data requested to be read is 1 terabyte (terabyte, TB). However, because data blocks requested to be read are dispersedly stored in merged data blocks, all these merged data blocks need to be read during reading. For example, if a total amount of such merged data may be 2 TB, the disk read amplification ratio is 2.

### (3) Data rewrite

In a redirect on write (redirect on write, ROW) storage system, a data block is redirected and written to a new location when being overwritten, and then an index table of the data block is modified. When the data block is deleted, only the index table is modified, and data in an original location of the data block on a storage medium is not erased. A process of redirecting and writing data to a new location is referred to as data rewrite. The data rewrite enables one data block to be stored in at least two storage units at the same time.

Currently, it is a common storage manner to store data after compressing the data. Merge compression is further a common data compression manner. However, after the merge compression, data read performance may be poor. For example, one read request is for requesting to read one data block A. Because the data block A is merged and compressed into a merged data block, to read the data block A, the merged data block needs to be read first, and the merged data block is decompressed, to obtain the data block A. A larger quantity of data blocks that need to be read indicates more data read operations that need to be performed. For example, even if two data blocks that need to be read are merged and compressed into a same merged data block, read operations need to be respectively performed on the two data blocks. This causes a disk read amplification ratio to increase. In addition, in this manner, after merged data blocks are obtained through reading, the merged data blocks need to be decompressed separately. Consequently, a required decompression calculation amount is larger, and data read performance is not high.

Therefore, how to resolve a problem of poor data read performance caused by the merge compression needs to be considered currently.

Based on this, embodiments of this application provide a data read method. In this method, after at least one first data block is merged and compressed into a second data block for storage, if P first data blocks are expected to be read, a second read request may be determined based on P first read requests corresponding to the P first data blocks, Q second data blocks may be obtained by performing a read operation based on the second read request, and the P first data blocks may be obtained based on data obtained by decompressing the Q second data blocks. However, in a related technology, although a plurality of data blocks are compressed into one compressed block, a read operation still needs to be performed for each read request during data reading. In implementations of embodiments of this application, the first read requests are merged, so that a quantity of read operations is reduced, a disk read amplification ratio is reduced, and data read performance is improved. In addition, if two first data blocks are merged and compressed into one second data block for storage, in an implementation of the related technology, when the two first data blocks are read, two corresponding read requests are separately executed, and an execution result is that the second data block is read twice. In addition, decompression operations are respectively performed on the two same second data blocks to respectively obtain the two first data blocks. This is equivalent to that, to read the two first data blocks, two decompression operations need to be performed on one second data block. However, in the implementations of embodiments of this application, the first read requests are merged, and only one time of reading and one decompression operation need to be performed on each second data block. This reduces the quantity of read operations, and reduces a calculation amount required for decompression.

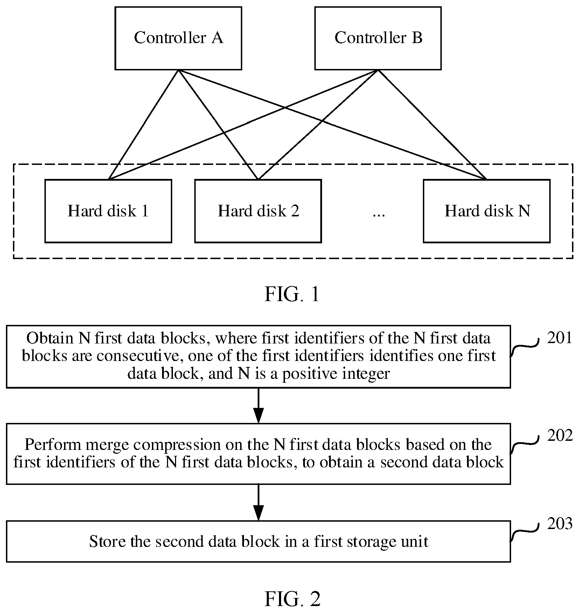

The method provided in embodiments of this application may be applied to a storage system. FIG. 1 is a diagram of an architecture of a possible application system in a solution according to an embodiment of this application. The storage system includes at least one controller and at least one storage device. As shown in FIG. 1, the storage device is specifically a hard disk. The controller is configured to control the storage device to implement a management responsibility of the storage system. The at least one storage device is configured to provide storage space to store data.

The at least one controller shown in FIG. 1 includes a controller A and a controller B. However, a quantity of controllers is not limited in an actual scenario. For example, there may be more controllers. The controller A and the controller B may be both in a working state, in other words, the controller A and the controller B may collaboratively complete the management responsibility of the storage system. Alternatively, the controller A and the controller B may use a highly available (highly available, HA) technology, in other words, the controller A and the controller B may be standby devices of each other.

The storage device may be a hard disk (hard disk drive, HDD), and the hard disk is configured to provide a storage resource, for example, store data. The hard disk may be a magnetic disk or another type of storage medium, for example, a solid state drive (solid state drive, SSD) or a shingled magnetic recording hard disk. The at least one storage device shown in FIG. 1 includes hard disks 1 to N. However, a quantity N of hard disks is not limited in embodiments of this application. The at least one storage device may also be referred to as a storage array, a magnetic disk array, or a hard disk array.

In an implementation, a storage unit in embodiments of this application may be a storage device, for example, a hard disk.

In another implementation, a storage unit in embodiments of this application may alternatively be a storage medium chunk (chunk, CK) or a storage medium chunk group (chunk group, CKG). A chunk is consecutive physical space of a fixed size on a hard disk. A chunk group is a logical set of CKs of different hard disks.

In an implementation, the controller and the storage device may be deployed in a same device, for example, a server. The server may include the controller and the storage device, and the controller and the storage device may be connected through a bus.

In another implementation, the controller and the storage device may be considered as different devices, and the controller and the storage device may be connected via a network. The network may be, for example, a wired network or a wireless network.

In embodiments of this application, the controller may include a processor and a memory. The processor and the memory are configured to provide a computing resource. Specifically, the processor may be a central processing unit (central processing unit, CPU), and is configured to process an access request from the outside (for example, a client) of the storage system, and is also configured to process a request generated inside the storage system. For example, when receiving data write requests from the client, the processor temporarily stores data in these data write requests in the memory. When a total amount of data in the memory reaches a specific threshold, the processor sends the data stored in the memory to the hard disk for persistent storage. In addition, the processor is further configured to perform calculation or processing on the data, for example, metadata management, data compression, data check, and translation of virtualized storage space and an address. During actual application, there are usually a plurality of processors, and one processor further has one or more processor cores. A quantity of processors and a quantity of processor cores are not limited in this application. The controller may further include a network interface card, and the network interface card is configured to communicate with the outside.

The memory is an internal storage that directly exchanges data with the processor. The data can be read and written in the memory at a high speed at any time, and the memory serves as a temporary data storage of an operating system or another running program. The memory includes at least two types of storages. For example, the memory may be a random access memory, or may be a read-only memory (ROM). For example, the random access memory is a dynamic random access memory (DRAM) or a storage class memory (SCM). The DRAM is a semiconductor memory, and is a volatile memory device like most random access memories (RAMs). The SCM is a composite storage technology that combines features of both a conventional storage apparatus and a storage. The SCM can provide a higher read/write speed than the hard disk, but an access speed is lower than that of the DRAM, and the cost is also lower than that of the DRAM. However, the DRAM and the SCM are merely examples for description in this embodiment. The memory may further include another random access memory, for example, a static random access memory (SRAM). For example, the read-only memory may be a programmable read-only memory (PROM) or an erasable programmable read-only memory (EPROM). In addition, the memory may alternatively be a dual in-line memory module or a dual in-line memory module (DIMM), namely, a module including DRAMs, or may be a solid state drive (SSD). During actual application, a plurality of memories may be configured in a storage node, and types of the plurality of memories may be different. A quantity of memories and a type of the memory are not limited in this embodiment. In addition, the memory may be further configured to have a power protection function. The power protection function means that data stored in the memory is not lost even when a system is powered on again after a power failure. A memory with a power protection function is referred to as a non-volatile memory.

It should be noted that the foregoing system architecture is merely an example description of a system architecture to which the solutions of this application are applicable, and does not constitute a limitation on the system architecture to which the solutions of this application are applicable. In the foregoing system architecture, another apparatus or module may be added, or a part of apparatuses or modules may be deleted or modified.

The following describes the solutions provided in this application with reference to specific embodiments. The solutions in embodiments of this application may be applied to a data storage and read scenario, for example, a sequential read/write scenario. For example, the sequential read/write scenario may include a data backup scenario.

Embodiments of this application provide a data read method and a data write method, to alleviate a problem of poor data read performance caused by merge compression while reducing redundant information and saving storage space by using a merge compression technology. The following first describes the data write method.

An embodiment of this application provides a data read method. FIG. 2 is a flowchart of the method. The method may be performed by a control apparatus, and the control apparatus is, for example, a controller of a storage system.

Step 201: Obtain N first data blocks, where first identifiers of the N first data blocks are consecutive, one of the first identifiers identifies one first data block, and N is a positive integer.

Each first identifier identifies one first data block. For example, the first identifier may be a logical location of the first data block, or identifies the logical location of the first data block. For example, the first identifier includes a storage address of the first data block and/or a sequence number of the first data block in a file.

In an implementation scenario, the storage system may be applied to a raw disk mapping scenario, for example, a server or database scenario. In these scenarios, after a storage raw disk is mapped to a server or a database, the server or the database needs to manage the raw disk based on a database file system of the server or the database. When the server or the database needs to read or write the first data block, the storage address of the first data block may be carried. The storage address may be, for example, a logical address. The logical address identifies an address used for a storage location of data. The logical address may be a logical block address (logical block address, LBA).

In this case, that the first identifiers of the N first data blocks are consecutive may be that storage addresses (for example, logical addresses) of the N first data blocks are consecutive.

In another implementation scenario, for storage of a large file, the file usually needs to be divided into a plurality of small data blocks for storage. For example, if the data blocks obtained by dividing the file may include the N first data blocks, the first identifier may be the sequence number that is of the first data block obtained through division and that is in the file, and a sequence number of one first data block in the file indicates a location of the first data block in the file. For example, if a large file is divided into a plurality of data blocks, the plurality of data blocks may be numbered in sequence, and one sequence number may be a number corresponding to one data block.

In this case, that the first identifiers of the N first data blocks are consecutive may be that sequence numbers of the N first data blocks in the file are consecutive. When the N first data blocks belong to a same file, the sequence numbers of the N first data blocks in the file are consecutive. When the N first data blocks belong to different files, sequence numbers of a part of the N first data blocks in a same file are consecutive. In addition, file identifiers of these files may be consecutive, and the file identifier may be a storage address, a file name, or the like of the file.

In this embodiment of this application, that the first identifiers of the N first data blocks are consecutive may include a case in which the first identifiers are strictly consecutive and a case in which the first identifiers are adjacent. In other words, the N first data blocks in this embodiment of this application may be consecutive blocks or adjacent blocks. The consecutive blocks are blocks whose first identifiers (for example, logical locations) are consecutive, but in the storage system, the blocks whose first identifiers are consecutive are not necessarily actually stored in consecutive locations in a storage medium. The adjacent blocks are blocks whose first identifiers (for example, logical locations) are adjacent, but in the storage system, the blocks whose first identifiers are adjacent are not necessarily actually stored in adjacent locations in the storage medium. In other words, the first identifiers of the N first data blocks may be consecutive or adjacent. For example, when first identifiers of a plurality of first data blocks are respectively 1, 2, 3, 4, and 5, or 5, 4, 3, 2, and 1, it is considered that the first identifiers of the plurality of first data blocks are consecutive. For the plurality of first data blocks, whether the first data blocks are adjacent blocks may be determined based on a maximum distance value of the plurality of first data blocks, and the maximum distance value is a maximum value of differences between the first identifiers of the plurality of first data blocks. When the maximum distance value is less than a distance threshold, it is considered that the plurality of first data blocks are adjacent blocks; otherwise, it is considered that the plurality of first data blocks are not adjacent blocks. The distance threshold may be related to a quantity of data blocks that can be cached in a memory of the storage system, namely, a size of data that can be read or written in a same batch. For example, a memory of a given storage system supports processing of 1000 first data blocks in a same batch. When first identifiers of a plurality of first data blocks are respectively 1, 2, 3, 4, and 6, or 6, 4, 3, 2, and 1, and a maximum distance value is less than 1000, it is considered that the first identifiers of the plurality of first data blocks are adjacent. When first identifiers of a plurality of first data blocks are respectively 1, 5, 10, 100, and 1001, or 1001, 100, 10, 5, and 1, and a maximum distance value is not less than 1000, it is considered that the first identifiers of the plurality of first data blocks are not adjacent, in other words, the plurality of first data blocks are not adjacent blocks.

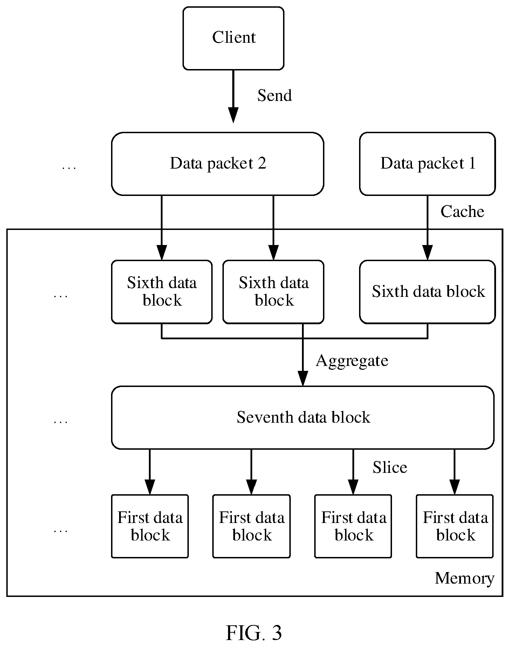

In this embodiment of this application, a to-be-stored first data block may be obtained based on a data packet sent by a client, and the client may also be referred to as a host. When a user needs to store data in the storage system, the user may initiate a data write request by using a client on user equipment. Alternatively, when the database needs to perform raw disk mapping, the database may initiate a data write request by using a client in the database. FIG. 3 is a diagram of obtaining the N first data blocks according to this embodiment of this application. The data write request sent by the client may carry at least one data packet, each of the at least one data packet may include one or more sixth data blocks, and first identifiers of the one or more sixth data blocks are consecutive. Correspondingly, the control apparatus may receive the at least one data packet from the client, and store the one or more sixth data blocks included in each of the at least one data packet in the memory until a specific persistence condition is met. For example, when a total amount of data in the memory reaches a specific threshold, writing the data into a hard disk for persistent storage according to the method in this embodiment of this application may be triggered. As shown in FIG. 3, a plurality of sixth data blocks stored in the memory may be aggregated. For example, sixth data blocks that belong to a same file are aggregated, or a plurality of (for example, a specified quantity of) consecutive sixth data blocks are aggregated based on a storage address, to obtain at least one seventh data block. In addition, the at least one seventh data block is sliced. For example, the at least one seventh data block may be sliced based on a preset fixed data block size, to obtain the N first data blocks.

The seventh data block may also be referred to as an aggregated data block. After the seventh data block is sliced, a data reduction operation may be further performed on the obtained data blocks. For example, deduplication may be performed on the data blocks obtained through slicing, to filter a duplicate data block, so that redundant data is reduced, and storage space usage is reduced. However, it should be noted that, for consecutive data, even if some data blocks are filtered after slicing, finally obtained first data blocks may also be considered as being consecutive.

The solution in this embodiment of this application may be applied to a sequential read/write scenario. The sequential read/write scenario may include a sequential write procedure and a sequential read procedure. A sequence of writing data blocks in the sequential write procedure may be the same as a sequence of reading data blocks in the sequential read procedure. For the sequential write procedure, data that needs to be stored may be cached in the memory in the foregoing manner. When sufficient consecutive data is cached in the memory, data obtained by aggregating the consecutive data is sliced based on a fixed size, to obtain a plurality of adjacent first data blocks.

In this embodiment of this application, a data storage may include a cache and a persistent storage. When data needs to be stored, the data may be first stored in the cache, and then the data is read from the cache and stored in the persistent storage. Correspondingly, the controller may include a cache layer and a persistence layer. The cache layer may be configured to cache the data, and the persistence layer may be configured to implement persistent storage of the data. In this case, the method in this embodiment of this application may be implemented by using the persistence layer. To be specific, when the cache layer caches a sufficient amount of data, the cache layer may send, to the persistence layer, an instruction instructing persistent storage, to persistently store the data in a storage unit.

Step 202: Perform merge compression on the N first data blocks based on the first identifiers of the N first data blocks, to obtain a second data block.

In this embodiment of this application, the second data block is a data block obtained through merge compression, and may also be referred to as a compressed block, a compressed data block, a merged and compressed block, or the like.

In a possible implementation, when merge compression is performed, the N first data blocks may be concatenated in a sequence of the first identifiers of the N first data blocks, to obtain a fifth data block. The fifth data block may also be referred to as a merged block or a merged data block. Then, after the fifth data block is compressed, the second data block may be obtained.

Concatenating the N first data blocks in the sequence of the first identifiers of the N first data blocks may be sorting the N first data blocks in a value sequence of the first identifiers, and concatenating the N first data blocks in a sequence obtained through sorting. For example, if each first data block may be a character string (for example, a binary-coded character string), N short character strings may be concatenated in a head-to-tail concatenation manner to obtain a long character string, and the long character string is the fifth data block.

In an actual scenario, there may be a large quantity of first data blocks obtained by slicing data obtained by aggregating consecutive data cached in the memory. In this case, these first data blocks may be grouped, and each group includes N first data blocks. N is only a quantity of first data blocks in each group, but values of N of different groups may be different.

Specifically, to avoid an excessively large amount of data in each group, which causes an excessively large amount of data to be read at a time during subsequent data reading or an excessively large decompression calculation amount required for decompressing one second data packet, in this embodiment of this application, a specific constraint condition may be further preconfigured for the group for division. For example, the constraint condition may be that the quantity of data blocks included in each group does not exceed a preset quantity threshold, in other words, N is less than or equal to a first threshold, where the first threshold is, for example, 16; and/or the constraint condition may be that a total length of data included in each group is less than or equal to a second threshold, in other words, a sum of lengths of the N first data blocks is less than or equal to the second threshold, where the second threshold is, for example, 128 kilobytes (kilobytes, KB). In this case, during grouping and division, division may be performed based on the constraint condition. To be specific, all first data blocks that need to be persistently stored are grouped into a plurality of groups, each group includes at least one (namely, N) first data block, and each group meets the constraint condition.

Further, the first data blocks in each group may be sequentially concatenated and merged into a large fifth data block. In addition, a sequence number of each sub-block (namely, the first data block) included in the fifth data block in the fifth data block is remembered. For example, the sequence number of each sub-block included in the fifth data block may be cached in the memory, and after being stored, the sequence number is updated to a related information table for storage.

In this embodiment of this application, when the fifth data block is compressed, the second data block may be obtained based on the fifth data block and third information.

The third information indicates locations of the N first data blocks in the fifth data block. For example, the third information includes a total quantity of the N first data blocks and a length of each of the N first data blocks, so that the locations of the first data blocks are determined in a data read or garbage collection procedure.

Generally, a compressed block includes a compression header, used to store information related to the compressed block, for example, integrity check code and a used compression algorithm. In this case, the third information may be a compression header, or the third information may be included in the compression header.

When the fifth data block is compressed, the fifth data block may be compressed to obtain a corresponding compressed block, and a compression header is added to the compressed block to obtain the second data block. For example, the compression header may be added before the compressed block.

Step 203: Store the second data block in a first storage unit.

After being generated, the second data block may be written into the storage medium. The foregoing mainly describes a write process of one second data block. However, during actual application, for a first data block that needs to be persistently stored each time, the foregoing method may be used to generate a plurality of second data blocks, and the second data blocks are separately written into the storage medium.

In this embodiment of this application, a storage unit may be a storage medium, for example, a hard disk, or may be a unit, for example, a chunk or a sector, in the storage medium. The storage medium is divided based on a specific size, and a chunk is a storage unit obtained through division.

For example, the storage medium may be divided into chunks of a specific size, and the chunks are prepared before a data write operation is performed. In this case, when a data block is written, a storage unit for storing the data block may be pre-allocated by using an allocation algorithm. For example, the first storage unit is a storage unit allocated to store the second data block. Then, the write operation is performed to write the second data block into the allocated first storage unit.

In addition, a third identifier and first information that are related to the second data block are remembered. A third identifier indicates a storage unit in which a second data block is located, or may be understood as indicating a storage unit to which each first data block corresponding to the second data block belongs. For example, the third identifier may be a number of a storage medium or a chunk number of a chunk. First information indicates a location of a second data block in a storage unit, or may be understood as indicating a location of each first data block corresponding to the second data block in the storage unit. For example, the first information may include a storage address offset and data length information of the second data block in a chunk.

In this embodiment of this application, after the write operation is performed on the second data block, second identifiers of the N first data blocks may be further stored. Each second identifier may indicate a location of one first data block. In other words, the foregoing recorded information may be stored in an index table, to facilitate querying a location of each first data block when the data block is read.

A second identifier of one first data block includes one or more of the following:
(1) Third identifier: The third identifier indicates a storage unit in which a second data block to which the first data block belongs is located. For example, the third identifier is a chunk number of a chunk.
(2) First information: The first information indicates a location of the second data block to which the first data block belongs in the first storage unit. For example, the first information includes a storage address offset and data length information of the second data block in a chunk.
(3) Second information: The second information indicates a location of the first data block in a fifth data block to which the first data block belongs, where the fifth data block is obtained by concatenating a plurality of first data blocks. For example, the second information includes a sequence number of the first data block in the fifth data block to which the first data block belongs.

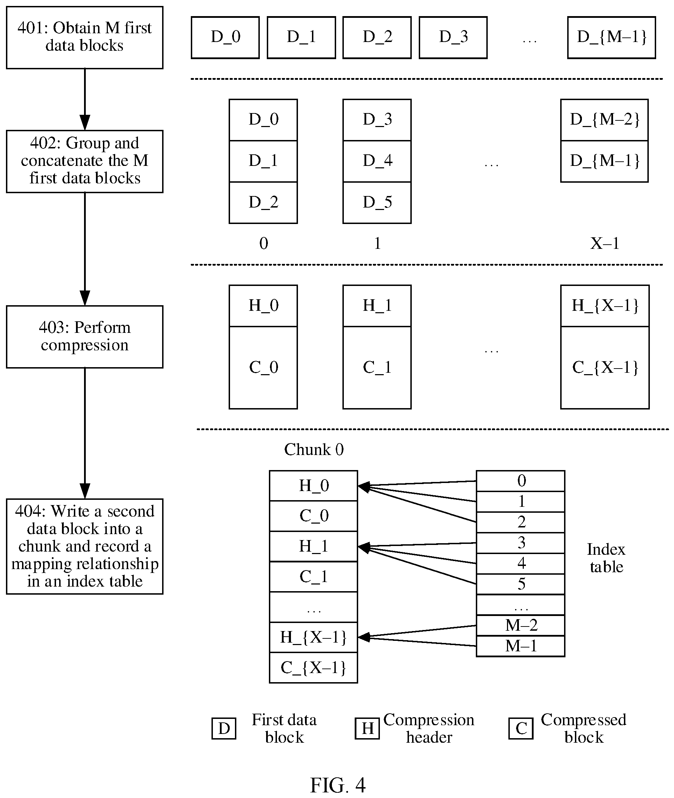

For example, FIG. 4 is a schematic flowchart of a data write process according to an embodiment of this application. The following specifically uses a sequential write scenario as an example for description.

Step 401: Obtain M first data blocks. Sufficient consecutive data may be cached in a memory, and then aggregated data is sliced based on a fixed size, to obtain the M first data blocks, for example, D_0 to D _{M-1} shown in FIG. 4. Each D represents one first data block.

Step 402: Group and concatenate the M first data blocks. As shown in FIG. 4, each group includes at least one data block and does not exceed a preconfigured configuration quantity condition, to obtain X groups, for example, groups 0 to X-1 shown in FIG. 4. The group 0 includes the first data blocks D_0 to D_2, the group 1 includes the first data blocks D_3 to D_5, and so on. Then, data blocks in each group are sequentially concatenated to obtain a fifth data block.

Step 403: Perform a compression operation. To be specific, the fifth data block obtained through concatenation is compressed into a compressed block, and a compression header is added before the compressed block. H represents the compression header, and C represents the compressed block.

Step 404: Write a second data block into a chunk and record a mapping relationship in an index table. As shown in FIG. 4, X second data blocks are written into a chunk 0, and a mapping relationship corresponding to each of the M first data blocks is recorded. The mapping relationship is a mapping relationship between a first identifier and a second identifier of the first data block. In this case, the second identifier of the first data block may be obtained by querying the mapping relationship based on the first identifier. The second identifier is index information of each first data block, and includes, for example, one or more of a chunk number of a chunk into which a second data block to which the first data block belongs is written, an offset and a length of the second data block to which the first data block belongs in the chunk, or a sequence number of the first data block in a fifth data block to which the first data block belongs.

In the data write process, when the first data blocks are stored, merge compression is performed on a plurality of first data blocks whose first identifiers are consecutive, to reduce redundant data and improve storage space utilization. In addition, because corresponding first data blocks in the obtained second data block are also consecutive, in comparison with a manner of selecting similar data blocks for merge compression in a related technology, in the manner in this embodiment of this application, consecutive first data blocks may be obtained from a smaller quantity of second data blocks during data reading, and a data read amount is smaller, in other words, a disk read amplification ratio is lower. In addition, because the quantity of second data blocks is smaller, a quantity of decompression times can be reduced, and a calculation amount required for decompression is reduced.

For example, in a merge compression method, similarity analysis is performed between a plurality of to-be-stored data blocks, and data blocks with a high similarity are selected for merge compression. In this merge compression method, one of the data blocks can be fully compressed during compression, and after the remaining data blocks are compared with the data block, only a difference part is stored. Data blocks in a single merged data block are data blocks with a high similarity, and a difference part is small, so that storage space usage can be effectively reduced. However, when this merge compression method is used, data blocks that are requested to be read may be dispersedly stored in merged data blocks, and these merged data blocks need to be separately read. Therefore, unnecessary data in the merged data blocks is also read, and a disk read amplification ratio increases. In addition, because the merged data block needs to be decompressed, a larger quantity of merged data blocks indicates a larger required decompression calculation amount. As a quantity of data blocks in a single merged data block increases, the disk read amplification ratio and the decompression calculation amount also increase. Consequently, data read performance of a data storage system deteriorates.

However, according to the data write method in this embodiment of this application, on the basis of reducing redundant data and improving storage space utilization, a manner of selecting consecutive data blocks for merge compression is used, so that a data read amount is smaller, in other words, a disk read amplification ratio is lower. In addition, because a quantity of times of reading the second data block is reduced, a quantity of decompression times can be reduced, and a calculation amount required for decompression is reduced.

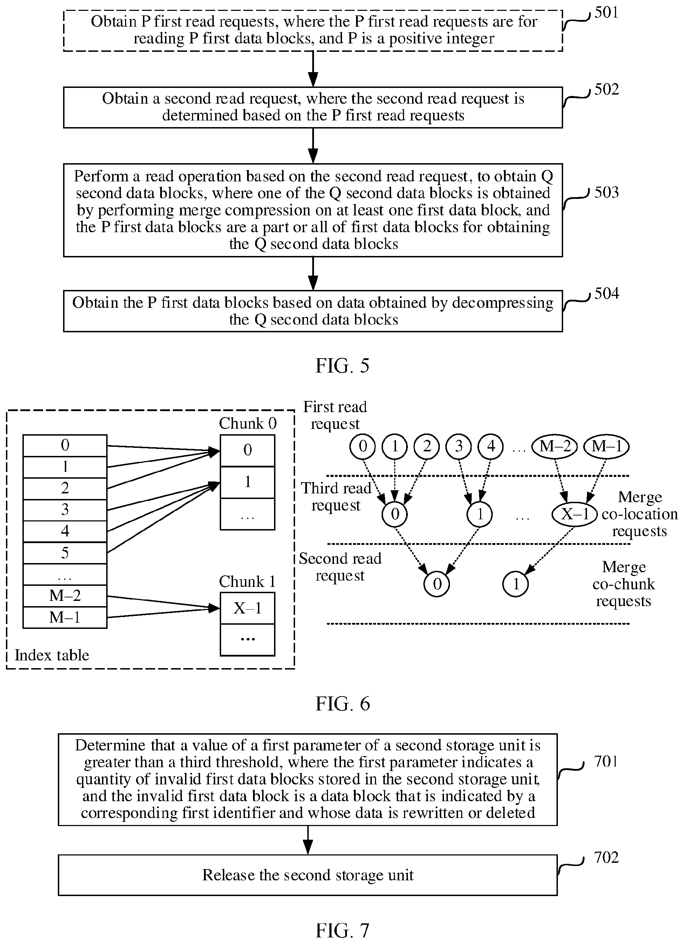

After a data block is written, the data block may be read from a storage medium when the data block is required. For example, in a backup scenario, after files are backed up and stored in a specific sequence, the files may be further read in the sequence. The following describes a data read method according to an embodiment of this application. FIG. 5 is a schematic flowchart of the method.

Step 501: Obtain P first read requests, where the P first read requests are for reading P first data blocks, and P is a positive integer.

The P first read requests are for reading the P first data blocks, and each first read request is for reading one first data block.

In a possible implementation, the P first read requests may be determined based on at least one piece of data read signaling sent by a client, each piece of data read signaling may be for reading one or more first data blocks, and the at least one piece of data read signaling is for requesting to read the P first data blocks.

In another possible implementation, in some data read scenarios, a data prefetching procedure may be performed. The data prefetching procedure means that data that may need to be read later is read into a memory in advance. In the prefetching procedure, a large amount of data may be read at a time, and a large batch of first read requests may be delivered. In this case, when it is determined that the data prefetching procedure needs to be performed in a scenario, for example, when the scenario is currently a sequential read scenario, data that needs to be read later may be read into the memory in advance by using the prefetching procedure. In this case, when the client needs to read the data and sends a read request to a control apparatus, the data may be directly obtained from the memory and returned to the client, to reduce a data read delay of the client.

In this case, when it is determined that the data prefetching procedure needs to be performed, a data block that needs to be prefetched may be determined based on a data block read by the client, and a corresponding first read request is generated. For example, if the control apparatus receives first signaling from the client, and the first signaling is for requesting to obtain a third data block, the control apparatus may determine the P first data blocks based on the first signaling, where the P first data blocks are data blocks associated with the third data block; and the control apparatus may determine the P first read requests based on the P first data blocks, where each first read request is for requesting to read one first data block. For example, each first read request may include a first identifier of a first data block that needs to be read by using the first read request, and the first identifier uniquely identifies one first data block. For example, the P first data blocks may be P data blocks after the third data block, or the P first data blocks include the third data block and P-1 data blocks after the third data block. The data blocks after the third data block are data blocks that are sorted based on first identifiers and that are sequentially located after the third data block. For example, the P data blocks herein may be P consecutive data blocks that are sequentially located after the third data block.

In this embodiment of this application, a data storage may include a cache and a persistent storage. When data needs to be read from the persistent storage, the data may be first read into the cache, and then the data is read from the cache. It may be understood that one piece of data may be stored in both the persistent storage and the cache. The cache is, for example, a memory, and the persistent storage is, for example, a hard disk. In this case, when data prefetching is triggered, a cache layer may deliver a large quantity of first read requests to a persistence layer.

In the sequential data read scenario, first identifiers of the P first data blocks that need to be read may be consecutive. For example, storage addresses of the P first data blocks are consecutive, where for example, consecutive first data blocks are read in a raw disk mapping scenario; and/or sequence numbers of the P first data blocks in a file are consecutive, where for example, when a large file is divided for storage, if a file needs to be read, consecutive first data blocks corresponding to the file are read. The file includes the P first data blocks, the P first data blocks may be a part or all of the first data blocks corresponding to the file, and a sequence number of the first data block indicates a location of the first data block in the file.

Step 501 is an optional step, and therefore is shown by using a dashed line in FIG. 5.

Step 502: Obtain a second read request, where the second read request is determined based on the P first read requests.

In this embodiment of this application, each first read request includes the first identifier of the correspondingly read first data block. In this case, second identifiers of the P first data blocks may be respectively obtained based on the first identifiers included in the P first read requests, and the P first read requests are merged based on the second identifiers of the P first data blocks, to obtain the second read request. Each first identifier identifies one first data block, and a second identifier of one of the P first data blocks indicates a location of the first data block. In this case, the first read requests may be merged based on the location of the first data block, where for example, first read requests at a same location may be merged, so that a plurality of first data blocks can be obtained by using one read operation. This reduces a quantity of read operations and improves data read performance.

One second identifier indicates a location of one first data block. The second identifier may also be referred to as an index or index information, and includes a plurality of implementations. For example, the second identifier may include one or a combination of more of the following implementations.

In an implementation, the second identifier includes a third identifier, and the third identifier indicates a storage unit in which a second data block to which the first data block belongs is located. For example, the third identifier is a chunk number of a chunk. In this case, the P first read requests may be merged based on storage units in which second data blocks to which the P first data blocks respectively belong are located. For example, first read requests in which first data blocks that need to be read are located in a same storage unit are merged into one second read request. It may be understood that, when a read operation corresponding to a read request is performed, metadata information of a storage unit needs to be queried. For example, a physical location of the storage unit is queried. In this case, after these first read requests are merged, for the second read request obtained by merging the first read requests corresponding to the first data blocks stored in the same storage unit, metadata information of the storage unit needs to be queried only once, so that data can be read from the corresponding storage unit. In comparison with a manner in which corresponding metadata information needs to be queried for each first read request when read operations are performed based on a plurality of first read requests, in the manner in this embodiment of this application, a quantity of times of querying the metadata information is effectively reduced, and the data read performance is improved. In addition, for a second data block that needs to be read by using one second read request, because the second data block is obtained by performing merge compression on a plurality of first data blocks, the plurality of first data blocks may be obtained by performing a read operation on the second data block. This reduces the quantity of read operations and improves the data read performance. In some scenarios, when two second data blocks are consecutively stored in a same storage unit, the two second data blocks may be read by using one read operation, to further reduce the quantity of read operations and improve the data read performance. For example, when a storage medium is an HDD or the like, such consecutive second data blocks may be read by using one read operation, so that the data read performance can be effectively improved.

In another implementation, the second identifier includes first information, and the first information indicates a location of the second data block to which the first data block belongs in the storage unit. For example, the first information includes a storage address offset and data length information of the second data block in a chunk. In this case, the P first read requests may be merged based on storage unit chunks in which second data blocks to which the P first data blocks respectively belong are located. For example, if first read requests at a same location in a storage unit are merged, first data blocks located in a same second data block may be obtained by performing one read operation. This reduces the quantity of read operations and improves the data read performance.

In another implementation, the second identifier includes second information, and the second information indicates a location of the first data block in a fifth data block to which the first data block belongs. The fifth data block is obtained by concatenating a plurality of first data blocks including the first data block, in other words, the fifth data block is obtained by decompressing the second data block to which the first data block belongs. For example, the second information includes a sequence number of the first data block in the fifth data block to which the first data block belongs. In this case, after Q second data blocks are read and Q fifth data blocks are obtained by performing a decompression operation on the Q second data blocks, the first data blocks of the P first read requests may be obtained from the fifth data blocks based on second information of the P first read requests.

During actual application, the second identifier may further include other information. This is not limited in this embodiment of this application.

Specifically, a mapping relationship between the second identifier and the first identifier may be stored in an index table. In this case, the second identifier that is of the corresponding first data block and that is recorded in the index table may be queried based on the first identifier included in each first read request. For example, the second identifier includes a chunk number of a chunk in which the second data block to which the first data block belongs is located, an address offset and a length of the second data block to which the first data block belongs in the chunk, and the sequence number of the first data block in the fifth data block to which the first data block belongs.

In this embodiment of this application, a merging process may be performed level by level when the P first read requests are merged.

First, it is determined, based on the second identifiers of the P first data blocks, that the P first data blocks are included in the Q second data blocks, where one of the Q second data blocks includes a part of the P first data blocks. In this case, first read requests corresponding to first data blocks that belong to a same second data block may be merged to obtain Q third read requests, where each third read request is for requesting to read one second data block. Further, after the Q third read requests are obtained through merging, when it is determined, based on the second identifiers of the P first data blocks, that the Q second data blocks are stored in a same storage unit, the Q third read requests are merged to obtain the second read request.

Specifically, when third identifiers and first information that are included in second identifiers of two first data blocks are the same, in other words, when indicated storage units in which second data blocks to which the first data blocks belong are located are the same and indicated locations of the second data blocks in the storage units are the same, the second identifiers indicate a same second data block, so that it is determined that the two first data blocks are included in the same second data block. Therefore, after second identifiers of first data blocks are obtained, first read requests whose corresponding third identifiers and first information are the same may be merged to obtain a third read request, and the third identifier and the first information are recorded in the third read request. The third read request is for reading a second data block jointly indicated by the third identifier and the first information. The third read request may also be referred to as a merged (merged) read request or a co-location request.

For example, if the third identifier is a chunk number of a chunk, and the first information is an address offset and a length of the second data block in the chunk, first read requests with a same chunk number of a chunk and a same address offset and length in the chunk may be merged to generate one third read request, to guide a data read and data decompression procedure. Based on this operation, all sub-requests in the third read request have the same chunk number of the chunk and the same address offset and length in the chunk, and the information is recorded in the third read request. In other words, read requests of data blocks that belong to a same second data block are merged into one third read request. A first data block that needs to be read by using a first read request corresponding to each third read request may be obtained by performing one read operation based on the third read request. This reduces a quantity of data read times and improves the data read performance.

After the Q third read requests are obtained through merging, third read requests that belong to a same storage unit may be further merged. Specifically, when third identifiers included in two third read requests are the same, in other words, when indicated storage units in which second data blocks to which first data blocks belong are located are the same, the third identifiers indicate a same storage unit, so that it is determined that the second data blocks are stored in the same storage unit. Therefore, after the Q third read requests are obtained through merging, third read requests that include a same third identifier may be merged to obtain the second read request, and the third identifier is recorded in the second read request. The second read request is for reading the Q second data blocks in the storage unit indicated by the third identifier. The second read request may also be referred to as a co-storage unit merging request. For a given second read request, it can be learned from the foregoing descriptions that first data blocks to be read by using all sub-requests (namely, first read requests) of the second read request belong to a same storage unit. Therefore, a third identifier that is of a storage unit and recorded in the index table and that is of a first data block to be read by using any sub-request may be used as a third identifier of a target storage unit that is requested to be read by using the second read request. Generally, when a read operation is performed, corresponding metadata information of a corresponding storage unit needs to be first queried for each read request. If there are a plurality of first read requests, metadata information needs to be queried for a plurality of times. In this embodiment of this application, read requests of a same storage unit are merged, and a second read request is obtained through merging. For each second read request obtained through merging, first data blocks that need to be read by using first read requests corresponding to the second read request are located in a same storage unit, and metadata information needs to be queried only once. This reduces a quantity of times of querying metadata information and improves data read efficiency. In addition, for each second data block that needs to be read by using one second read request, because the second data block is obtained by performing merge compression on a plurality of first data blocks, the plurality of first data blocks may be obtained by performing a read operation on the second data block. This reduces the quantity of read operations and improves the data read performance. In some scenarios, when two second data blocks are consecutively stored in a same storage unit, the two second data blocks may be read by using one read operation, to further reduce the quantity of read operations and improve the data read performance. For example, when a storage medium is an HDD or the like, such consecutive second data blocks may be read by using one read operation, so that the data read performance can be effectively improved.

For example, if the third identifier is a chunk number of a chunk, third read requests including a same chunk number of a chunk may be merged to generate one second read request. Based on this operation, a batch of third read requests may be re-merged based on a chunk number of a target chunk of the batch of third read requests, to obtain a second read request for reading a same chunk. All sub-requests in the second read request have a same chunk number of the chunk, and the information is recorded in the second read request. In other words, read requests for second data blocks that belong to a same chunk are merged into one second read request.

FIG. 6 is an example diagram of a merging process. First identifiers of M first data blocks that need to be read are respectively 0 to M-1. That a part of the first data blocks are stored in a chunk 0, and the other part of the first data blocks are stored in a chunk 1 may be obtained by querying the index table. A chunk number of a chunk in which a second data block corresponding to each first data block is located and location information (for example, an address offset and a length) of the second data block in the chunk may be obtained. For example, a first data block whose first identifier is 0 belongs to a second data block 0, and is stored in the chunk whose chunk number is chunk 0. In addition, location information of the second data block may be obtained.

On this basis, first read requests corresponding to first data blocks with a same chunk number and same location information of a second data block may be merged, to obtain a third read request. In other words, first read requests corresponding to first data blocks that belong to a same second data block may be merged, or first read requests at a same read location may be merged. As shown in FIG. 6, first data blocks 0 to 2 belong to a second data block. In this case, first read requests for reading the three first data blocks are merged, to generate a third read request for reading the second data block 0.

Finally, third read requests with a same chunk number are merged to obtain a second read request. In other words, third read requests that belong to a same chunk are merged. As shown in FIG. 6, third read requests for reading second data blocks 0 and 1 correspond to a same chunk, and are all for reading based on the chunk 0. In this case, these third read requests are merged to generate a second read request for accessing based on the chunk 0.

Step 503: Perform a read operation based on the second read request, to obtain the Q second data blocks, where one of the Q second data blocks is obtained by performing merge compression on at least one first data block, and the P first data blocks are a part or all of first data blocks for obtaining the Q second data blocks.

For a given second read request, a physical location of a target storage unit is queried based on a third identifier of the target storage unit corresponding to the second read request. Alternatively, when a target storage unit is a chunk in a storage medium, a physical location of the target storage unit in the storage medium may be queried based on a third identifier, and the physical location is recorded in the second read request, or the physical location is recorded in each third read request included in the second read request. For example, if the target storage unit is a chunk, and the third identifier is a chunk number of the chunk, a physical location of the chunk may be queried based on the chunk number, and is recorded in the second read request or each third read request included in the second read request.

A mapping relationship between the third identifier and the target storage unit may be stored in an index table. The index table may be dedicated to storing a mapping relationship between a third identifier of a storage unit and the storage unit. In this case, the physical location of the target storage unit may be obtained by querying the index table.

In this case, when the read operation is performed based on the second read request, the target storage unit may be located based on the found physical location of the storage unit, and data may be read from the target storage unit based on an address offset and a length of each third read request (or a second data block that needs to be read) in the target storage unit that are found in the foregoing step, to obtain the Q second data blocks.

Step 504: Obtain the P first data blocks based on data obtained by decompressing the Q second data blocks.

Specifically, the second data block is obtained by performing a compression operation on a fifth data block, and the fifth data block is obtained by concatenating at least one first data block. In this case, the Q second data blocks are decompressed to obtain the Q fifth data blocks. To be specific, a decompression operation is performed on each of the Q second data blocks, to obtain a fifth data block corresponding to the second data block. For example, if a decompression operation is performed on a compressed block, namely, a data part other than a compression header, included in each second data block, the fifth data block corresponding to the second data block may be obtained.

In addition, third information of the Q fifth data blocks may be further obtained based on the Q second data blocks. For example, third information of the corresponding fifth data block may be obtained from the compression header of the second data block, where one piece of third information indicates a location of at least one first data block corresponding to one fifth data block in the fifth data block. For example, one piece of third information includes a total quantity of first data blocks included in one fifth data block and a length of each first data block included in the fifth data block.

Further, the P first data blocks may be obtained from the Q fifth data blocks based on the third information of the Q fifth data blocks. For a sub-block (namely, a first data block) with a given sequence number, lengths of all sub-blocks with smaller sequence numbers are summed up, to obtain an offset of the sub-block with the given sequence number in a fifth data block obtained through decompression. For example, if a sequence number of a first data block that needs to be read is 3, lengths of first data blocks whose sequence numbers are 0 to 2 cond data block. For example, if the total length of the second data block is 10 KB, and the quantity of first data blocks is 4, the equivalent length of each first data block is 2.5 KB. Alternatively, an equivalent length of each first data block may be determined by a remainder and a value obtained by dividing a total length of a second data block by a quantity of first data blocks corresponding to the second data block. For example, if the total length of the second data block is 10 KB, and the quantity of first data blocks is 6, the equivalent length of each first data block may be determined based on a quotient being 1 of 10/6 and a remainder being 4. For example, an equivalent length occupied by each of the first four first data blocks is 2 KB, and an equivalent length occupied by each of the last two first data blocks is 1 KB.

During actual application, a length of a data block may be measured by using a quantity of sectors used for storing the data block. In this case, the equivalent length may alternatively be determined based on a total quantity of sectors occupied by a second data block and a quantity of first data blocks. For example, if an amount of data stored in one sector is 512 B, the second data block occupies 10 sectors in total, and the quantity of first data blocks is 6, the equivalent length of each first data block may be determined based on a quotient being 1 of 10/6 and a remainder being 4. For example, an equivalent length occupied by each of the first four first data blocks is two sectors, and an equivalent length occupied by each of the last two first data blocks is one sector. In addition, a mapping relationship between each first data block and a quantity of sectors occupied by the first data block is established. During index validity analysis, a quantity of sectors occupied by each invalid first data block may be determined based on the mapping relationship, then a total quantity of sectors occupied by invalid first data blocks in one second storage unit is determined as a total length of the invalid first data blocks, and further the value is used as a first parameter.

(4) Ratio of a sum of lengths of the invalid first data blocks to a total length of data stored in the second storage unit: The length is a length occupied by the invalid first data block in a corresponding second data block. The length herein may be expressed with reference to the manner in (3). Therefore, details are not described again.

A situation of garbage data in each storage unit may be determined by collecting statistics on the first parameter, and a storage unit with a large amount of garbage data may be preferentially selected for garbage collection, to reduce an amount of valid data that needs to be migrated when the storage unit is released, and improve garbage collection efficiency.

The third threshold is a preconfigured value, and indicates that an amount of garbage data in a storage unit is large. When a value of a first parameter of a storage unit is greater than the third threshold, it may be considered that garbage collection needs to be performed on the storage unit. During actual application, the third threshold may be configured based on a specific situation, may be configured based on a load of a storage system, or may be configured based on a proportion of idle storage space that needs to be maintained by the storage system. This is not specifically limited.

Step 702: Release the second storage unit.

In the data write method in embodiments of this application, merge compression is performed on a plurality of first data blocks for storage. Therefore, in the garbage collection process, processing of a second data block obtained through merge compression needs to be considered. One second data block may be classified into the following three types based on validity of sub-blocks (namely, first data blocks) of the second data block.
(1) All the sub-blocks are valid, to be specific, all the first data blocks corresponding to the second data block are valid first data blocks.
(2) A part of the sub-blocks are valid, to be specific, a part of the first data blocks corresponding to the second data block are valid first data blocks, and the other part of the first data blocks are invalid first data blocks.
(3) All the sub-blocks are invalid, to be specific, all the first data blocks corresponding to the second data block are invalid first data blocks.

Specifically, releasing the second storage unit may include: migrating data corresponding to a valid first data block in the second storage unit to a third storage unit, where the third storage unit is a storage unit different from the second storage unit. The migration may refer to storing the data in the third storage unit, and data in the second storage unit such as garbage data or data that has been stored in another storage unit may be deleted or may not be deleted, which may be determined based on a type of a storage medium. For example, if the storage medium is a storage medium that supports a deletion operation, for example, a formatting operation, a formatting operation may be performed on the second storage unit. Alternatively, if the storage medium is a storage medium that supports overwrite, to be specific, data may be directly overwritten into the storage medium based on original data, the data in the second storage unit may not be cleared, and the second storage unit is directly used as an idle storage unit.

Specifically, when the data of the valid first data block is migrated to the third storage unit, if the second data block is a second data block whose corresponding first data blocks are all valid, the second data block may be directly stored in the third storage unit; or if the second data block is a second data block whose corresponding first data blocks are partially invalid, only a valid first data block in the second data block is stored in the third storage unit.

In a possible implementation, in a data migration process, storage may still be performed in an original data block sequence. For example, if in the second storage unit, first data blocks are in ascending order in a sequence of first identifiers, after data migration, on the basis of removing an invalid first data block from each second data block, first data blocks may still be stored after merge compression is performed on the first data blocks in a sequence of first identifiers.

Specifically, for the second data block whose corresponding first data blocks are partially invalid, when the valid first data blocks are stored in the third storage unit, the second data block may be decompressed, and re-merge compression is performed on the valid first data block based on an order of a first identifier, to obtain at least one new second data block, and further store the at least one newly obtained second data block in the third storage unit.

In a possible implementation, in a data migration process, the data in the second storage unit may be processed in batches. For example, a total quantity of data blocks processed in each batch does not exceed a specific threshold, for example, does not exceed 32; or a total length of data blocks processed in each batch does not exceed a specific threshold, for example, does not exceed 1 MB. For each batch of data, data migration may be completed in the foregoing manner.

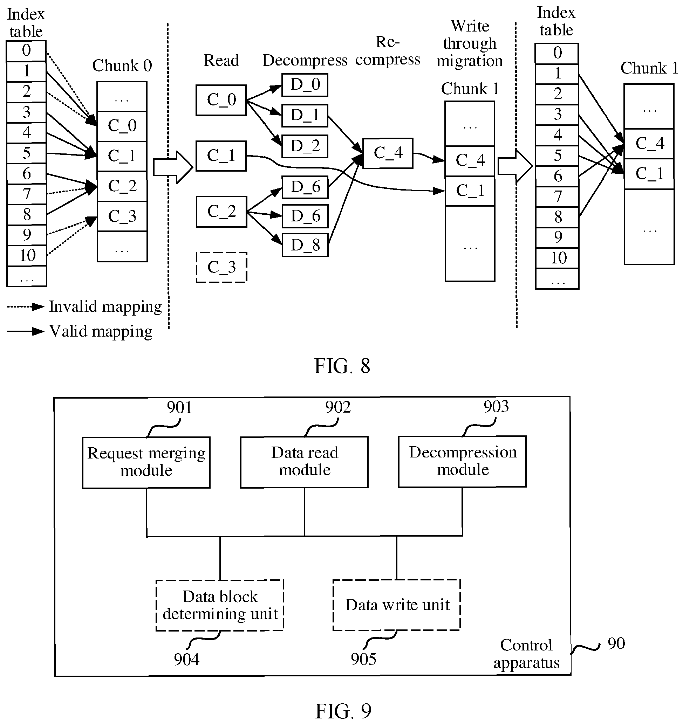

For example, FIG. 8 is an example diagram of a garbage collection process.

As shown in FIG. 8, when index validity analysis is performed on a chunk 0, it may be determined that first data blocks 0, 2, 7, 9, and 10 in an index table have been rewritten into another chunk, and mapping between the first data blocks 0, 2, 7, 9, and 10 and second data blocks in the chunk 0 is invalid. For example, the first data blocks 0 and 2 are originally merged and compressed into a second data block C_0 in the chunk 0 for storage. However, because the first data blocks 0 and 2 are rewritten, a mapping relationship between the first data blocks 0 and 2 and the second data block C_0 in the chunk 0 is invalid. In this case, these first data blocks in the chunk 0 are identified as garbage data.

Refer to FIG. 8. When garbage collection is performed on the chunk 0, data in the chunk 0 may be read. Specifically, for each second data block, data whose sub-blocks are all valid and data whose sub-blocks are partially valid may be read, and data whose sub-blocks are all invalid is discarded. As shown in FIG. 8, second data blocks C_0 to C_2 may be read, and C_3 is discarded.

For the read second data blocks, a second data block whose sub-blocks are all valid is not decompressed, a second data block whose sub-blocks are partially valid is decompressed, and data that belongs to the valid sub-block is extracted from the second data block whose sub-blocks are partially valid. As shown in FIG. 8, for the read second data block C_0, because first data blocks D_0 and D_2 included in the second data block C_0 are invalid, the second data block C_0 needs to be decompressed to obtain a valid first data block D_1. Similarly, for the read second data block C_2, because a first data block D_7 included in the second data block C_2 is invalid, the second data block C_2 needs to be decompressed to obtain valid first data blocks D_6 and D_8. However, for the read second data block C_1, because first data blocks corresponding to the second data block C_1 are all valid, re-merge compression does not need to be performed on the second data block C_1.

For all valid first data blocks that are obtained through decompression and that are processed in a current batch, re-grouping and re-merge compression may be performed in the foregoing manner. As shown in FIG. 8, re-merge compression is performed on the first data blocks D_1, D_6, and D_8 to form a new second data block C_4.

Then, the read second data block whose sub-blocks are all valid and second data blocks obtained through re-grouping and re-compression may be written into a new storage medium chunk, new index information is obtained, and the new index information is updated to the index table. As shown in FIG. 8, the second data blocks C_1 and C_4 are stored in a chunk 1, and mapping relationships in the index table are updated.

Finally, space of the selected storage unit chunk 0 is released, for example, marked as idle, or marked as idle after data is cleared. In this way, space reclamation of the chunk 0 ends.

In conclusion, in the data write method provided in embodiments of this application, adjacent data blocks are selected for merge compression, so that more data blocks appear in a merged and compressed data block during data reading, and especially for a sequential read/write scenario, a plurality of blocks that need to be read at the same time are more likely to appear in a same merged and compressed block, to reduce a quantity of merged and compressed data blocks that need to be read, and reduce a disk read amplification ratio and a decompression calculation amount. **In** the data read method provided in embodiments of this application, read locations of read requests are identified, and read requests at a same location are merged, to reduce a quantity of read operations, and reduce the disk read amplification ratio and the decompression calculation amount in a read procedure. **In** addition, whether to perform read, decompression, and re-merge compression is determined based on data validity of a merged block by using a garbage collection procedure, to reduce read amplification and decompression calculation amount amplification in the garbage collection procedure. During data migration, re-merge compression is performed on adjacent data blocks, to maintain a compression ratio.

Based on a same technical concept as the foregoing method embodiments, embodiments of this application further provide control apparatuses. The control apparatus is a module configured to perform the data read method or the data write method in the foregoing method embodiments.

In an example, as shown in FIG. 9, a control apparatus 90 includes a request merging module 901, a data read module 902, and a decompression module 903. Specifically, in the control apparatus 90, a connection is established between the modules through a communication path.

The request merging module 901 is configured to obtain a second read request. The second read request is determined based on P first read requests, the P first read requests are for reading P first data blocks, and P is a positive integer.

The data read module 902 is configured to perform a read operation based on the second read request, to obtain Q second data blocks. One of the Q second data blocks is obtained by performing merge compression on at least one first data block, and the P first data blocks are a part or all of first data blocks for obtaining the Q second data blocks.

The decompression module 903 is configured to obtain the P first data blocks based on data obtained by decompressing the Q second data blocks.

In a possible implementation, the control apparatus 90 further includes a data block determining unit 904, configured to:
receive first signaling from a client, where the first signaling is for requesting to obtain a third data block;
determine the P first data blocks based on the first signaling, where the P first data blocks are data blocks associated with the third data block; and
determine the P first read requests based on the P first data blocks.

In a possible implementation, the data block determining unit 904 is further configured to:
store the P first data blocks in a memory;
receive second signaling from the client, where the second signaling is for requesting to obtain a fourth data block, and the fourth data block includes a part or all of the P first data blocks; and
obtain the fourth data block from the memory, and send the fourth data block to the client.

In a possible implementation, first identifiers of the P first data blocks are consecutive, and each first identifier identifies one first data block.

In a possible implementation, that the first identifiers of the P first data blocks are consecutive includes:
Storage addresses of the P first data blocks are consecutive; and/or
sequence numbers of the P first data blocks in a file are consecutive, the file includes the P first data blocks, and the sequence number indicates a location of one first data block in the file.

In a possible implementation, the request merging module 901 is specifically configured to:
obtain second identifiers of the P first data blocks based on the first identifiers included in the P first read requests, where each first identifier identifies one first data block, and a second identifier of one of the P first data blocks indicates a location of the first data block; and
merge the P first read requests based on the second identifiers of the P first data blocks, to obtain the second read request.

In a possible implementation, the second identifier of the first data block includes one or more of the following:
a third identifier, indicating a storage unit in which a second data block to which the first data block belongs is located;
first information, indicating a location of the second data block to which the first data block belongs in the storage unit; and
second information, indicating a location of the first data block in a fifth data block to which the first data block belongs, where the fifth data block is obtained by decompressing the second data block to which the first data block belongs.

In a possible implementation, the request merging module 901 is specifically configured to:
determine, based on the second identifiers of the P first data blocks, that the P first data blocks are included in the Q second data blocks, where one of the Q second data blocks includes a part of the P first data blocks;
merge first read requests corresponding to first data blocks that belong to a same second data block, to obtain Q third read requests;
determine, based on the second identifiers of the P first data blocks, that the Q second data blocks are stored in a same storage unit; and
merge the Q third read requests to obtain the second read request.

In a possible implementation, the decompression module 903 is specifically configured to:
decompress the Q second data blocks to obtain Q fifth data blocks, where one of the Q fifth data blocks is obtained by concatenating at least one first data block;
obtain third information of the Q fifth data blocks, where one piece of third information indicates a location of each of at least one first data block corresponding to one fifth data block in the fifth data block; and
obtain the P first data blocks from the Q fifth data blocks based on the third information of the Q fifth data blocks.

In a possible implementation, the piece of third information includes a total quantity of first data blocks included in the fifth data block and a length of each first data block included in the fifth data block.

In a possible implementation, the control apparatus 90 further includes a data write unit 905, configured to:
obtain N first data blocks, where first identifiers of the N first data blocks are consecutive, each first identifier identifies one first data block, and N is a positive integer;
perform merge compression on the N first data blocks based on the first identifiers of the N first data blocks, to obtain a second data block; and
store the second data block in a first storage unit.

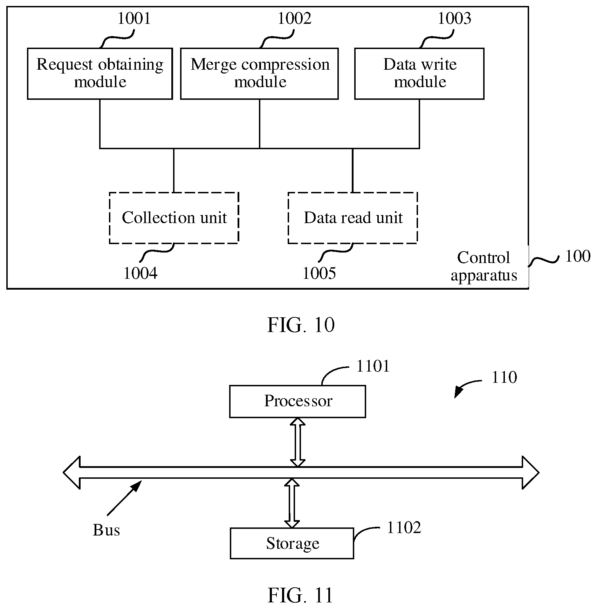

In an example, as shown in FIG. 10, a control apparatus 100 includes a request obtaining module 1001, a merge compression module 1002, and a data write module 1003. Specifically, in the control apparatus 100, a connection is established between the modules through a communication path.

The request obtaining module 1001 is configured to obtain N first data blocks. First identifiers of the N first data blocks are consecutive, each first identifier identifies one first data block, and N is a positive integer.

The merge compression module 1002 is configured to perform merge compression on the N first data blocks based on the first identifiers of the N first data blocks, to obtain a second data block.

The data write module 1003 is configured to store the second data block in a first storage unit. In a possible implementation, the first identifier includes:
a storage address of the first data block; and/or
a sequence number of the first data block in a file, where the file includes the N first data blocks, and the sequence number of the first data block in the file indicates a location of the first data block in the file.

In a possible implementation, the request obtaining module 1001 is specifically configured to:
receive at least one data packet from a client, where each of the at least one data packet includes one or more sixth data blocks, and first identifiers of the one or more sixth data blocks are consecutive;
store, in a memory, the one or more sixth data blocks included in each of the at least one data packet;
aggregate a plurality of sixth data blocks stored in the memory, to obtain at least one seventh data block; and
slice the at least one seventh data block to obtain the N first data blocks.

In a possible implementation, the merge compression module 1002 is specifically configured to:
concatenate the N first data blocks in a sequence of the first identifiers of the N first data blocks, to obtain a fifth data block; and
compress the fifth data block to obtain the second data block.

In a possible implementation, N is less than or equal to a first threshold; and/or a sum of lengths of the N first data blocks is less than or equal to a second threshold.

In a possible implementation, the merge compression module 1002 is specifically configured to:
obtain the second data block based on the fifth data block and third information, where the third information indicates locations of the N first data blocks in the fifth data block.

In a possible implementation, the third information includes a total quantity of the N first data blocks and a length of each of the N first data blocks.

In a possible implementation, the data write module 1003 is further configured to:
store second identifiers of the N first data blocks, where each second identifier indicates a location of one first data block.

A second identifier of one of the N first data blocks includes one or more of the following:
a third identifier, indicating the storage unit in which the second data block to which the first data block belongs is located;
first information, indicating a location of the second data block to which the first data block belongs in the first storage unit; and
second information, indicating a location of the first data block in the fifth data block to which the first data block belongs, where the fifth data block is obtained by decompressing the second data block to which the first data block belongs.

In a possible implementation, the control apparatus 100 further includes a collection unit 1004, configured to:
determine that a value of a first parameter of a second storage unit is greater than a third threshold, where the first parameter indicates a quantity of invalid first data blocks stored in the second storage unit, and the invalid first data block is a data block that is indicated by a corresponding first identifier and whose data is rewritten or deleted; and
release the second storage unit.

In a possible implementation, the collection unit 1004 is specifically configured to:
store, in a third storage unit, a second data block whose corresponding first data blocks are all valid; and
store, in the third storage unit, a valid first data block in a second data block whose corresponding first data blocks are partially invalid, where the valid first data block is a data block other than the invalid first data block.

In a possible implementation, the collection unit 1004 is specifically configured to:
perform merge compression on the valid first data block based on an order of a first identifier, to obtain at least one second data block; and
store the at least one second data block in the third storage unit.

In a possible implementation, the first parameter includes one or more of the following:
the quantity of invalid first data blocks;
a ratio of the quantity of invalid first data blocks to a total quantity of first data blocks stored in the second storage unit;
a sum of lengths of the invalid first data blocks, where the length is a length occupied by the invalid first data block in a corresponding second data block; or
a ratio of a sum of lengths of the invalid first data blocks to a total length of data stored in the second storage unit, where the length is a length occupied by the invalid first data block in a corresponding second data block.

In a possible implementation, the control apparatus 100 further includes a data read unit 1005, configured to:
determine a second read request, where the second read request is determined based on P first read requests, the P first read requests are for reading P first data blocks, and P is a positive integer;
perform a read operation based on the second read request, to obtain Q second data blocks, where one of the Q second data blocks is obtained by performing merge compression on at least one first data block, and the P first data blocks are a part or all of first data blocks for obtaining the Q second data blocks; and
obtain the P first data blocks based on data obtained by decompressing the Q second data blocks.

Module division in embodiments of this application is an example, and is merely logical function division. During actual implementation, there may be another division manner. In addition, functional modules in embodiments of this application may be integrated into one processor or may exist alone physically, or two or more modules may be integrated into one module. The integrated module may be implemented in a form of hardware, or may be implemented in a form of a software functional module. In the diagrams of FIG. 9 and FIG. 10, units represented by dashed lines are optional functional units.

If the integrated module is implemented in the form of the software functional module and sold or used as an independent product, the integrated module may be stored in a computer-readable storage medium. Based on such an understanding, the technical solutions of this application essentially, or the part contributing to a conventional technology, or all or a part of the technical solutions may be implemented in a form of a software product. The computer software product is stored in a storage medium and includes several instructions for enabling a computer device (which may be a personal computer, a mobile phone, or a network device) or a processor (processor) to perform all or a part of the steps of the methods in embodiments of this application. The storage medium includes any medium that can store program code, such as a USB flash drive, a removable hard disk, a read-only memory (read-only memory, ROM), a random access memory (random access memory, RAM), a magnetic disk, an optical disc, or the like.

In some other embodiments, a structure of a control apparatus 110 provided in embodiments of this application may be shown in FIG. 11, and includes a processor 1101 and a storage 1102 connected to the processor 1101. The processor 1101 and the storage 1102 may be connected to each other through a bus. The processor 1101 may be used as a main processor of the control apparatus 110, namely, a control core of the control apparatus 110. The bus may be a peripheral component interconnect (peripheral component interconnect, PCI) bus or an extended industry standard architecture (extended industry standard architecture, EISA) bus, or the like. The bus may be classified into an address bus, a data bus, a control bus, and the like. A specific connection medium between the processor 1101 and the storage 1102 is not limited in this embodiment of this application.

The storage 1102 may include the foregoing memory. The storage 1102 may be a volatile memory, for example, a random access memory. Alternatively, the storage may be a non-volatile memory, for example, a read-only memory ROM, a flash memory, a hard disk (hard disk drive, HDD), or a solid state drive (solid state drive, SSD). Alternatively, the storage 1102 is any other medium that can for carrying or storing expected program code in a form of an instruction or a data structure and that can be accessed by a computer, but is not limited thereto. The storage 1102 may be a combination of the foregoing storages. The storage 1102 may be configured to store a software program and a module.

The processor 1101 may include one or more processors. The processor 1101 runs the software program and the module that are stored in the storage 1102, to perform various function applications and data processing of the control apparatus 110, for example, the data write method or the data read method provided in embodiments of this application.

It may be understood that the structure shown in this embodiment of this application does not constitute a specific limitation on the control apparatus. In some other embodiments of this application, an electronic device may include more or fewer components than those shown in the figure, or combine some components, or split some components, or have different component arrangements. The components shown in the figure may be implemented by hardware, software, or a combination of software and hardware.

The method steps in embodiments of this application may be implemented in a hardware manner, or may be implemented in a manner of executing a computer program or instructions by the processor. The computer program or the instructions may constitute a computer program product. An embodiment of this application further provides a computer program product. The computer program product includes computer-executable instructions. In an embodiment, the computer-executable instructions are for enabling a computer to perform functions in the foregoing method embodiments.

The computer-executable instructions may be stored in a computer-readable storage medium. An embodiment of this application further provides a computer-readable storage medium, and the computer-readable storage medium stores executable instructions. In an embodiment, the computer-executable instructions are for enabling a computer to perform functions in the foregoing method embodiments.

The computer-readable storage medium provided in this embodiment of this application may be a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk, a removable hard disk, a CD-ROM, or any other form of computer-readable storage medium well-known in the art.

The computer-executable instructions may be stored in the computer-readable storage medium, or may be transmitted from a computer-readable storage medium to another computer-readable storage medium. For example, a computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape, or may be an optical medium, for example, a digital video disc (digital video disc, DVD), or may be a semiconductor medium, for example, a solid state drive.

An embodiment of this application further provides a computer program product, including instructions. When the instructions are run on a computer, the computer is enabled to perform the methods performed by the control apparatus in FIG. 2, FIG. 5, and FIG. 7.

An embodiment of this application provides a chip system. The chip system includes a processor and an interface. The processor is configured to invoke instructions from the interface and run the instructions, so that the chip system implements the methods in the foregoing embodiments. The chip system may include a chip, or may include the chip and another discrete component.

An embodiment of this application further provides a chip. The chip includes a processor configured to support a communication apparatus in implementing functions of the control apparatus in the foregoing method embodiments. In a possible design, the chip is connected to a storage, or the chip includes the storage. The storage is configured to store a computer program or instructions and data that are necessary for the communication apparatus.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

A person of ordinary skill in the art may be aware that, illustrative logical blocks (illustrative logical blocks) and steps (steps) described with reference to embodiments disclosed in this specification may be implemented by electronic hardware, computer software, or a combination of computer software and electronic hardware. Whether these functions are performed in a hardware or software manner depends on specific applications and design constraint conditions of the technical solutions. A person skilled in the art may use different methods to implement the described functions for each specific application. However, it should not be considered that this implementation goes beyond the scope of this application.

It may be clearly understood by a person skilled in the art that, for the purpose of convenient and brief description, for specific working processes of the foregoing systems, apparatuses, and units, refer to corresponding processes in the foregoing method embodiments. Details are not described herein again.

In several embodiments provided in this application, it should be understood that the disclosed systems, apparatuses, and methods may be implemented in other manners. For example, the described apparatus embodiments are merely examples. For example, division into the units is merely logical function division. During actual implementation, another division manner may be used. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electronic, a mechanical, or another form.

The units described as separate parts may or may not be physically separate, and parts displayed as units may or may not be physical units, in other words, may be located in one position, or may be distributed on a plurality of network units. A part or all of the units may be selected based on an actual requirement to achieve objectives of the solutions in the embodiments.

If the functions are implemented in a form of a software functional unit and sold or used as an independent product, the functions may be stored in a computer-readable storage medium. Based on such an understanding, the part of the technical solutions of this application that essentially makes a contribution or a part of the technical solutions may be implemented in a form of a software product. The computer software product is stored in a storage medium, and includes several instructions for enabling a computer device (which may be a personal computer, a server, or a network device) to perform all or a part of the steps of the methods described in embodiments of this application. The storage medium includes any medium that can store program code, such as a USB flash drive, a removable hard disk, a read-only memory (read-only memory, ROM), a RAM, a magnetic disk, an optical disc, or the like.

Certainly, a person skilled in the art may make various modifications and variations to this application without departing from the scope of this application. In this case, this application is intended to cover these modifications and variations of this application provided that they fall within the scope of protection defined by the following claims and their equivalent technologies.

## Claims

1. A data read method, wherein the method comprises:
obtaining a second read request, wherein the second read request is determined based on P first read requests, the P first read requests are for reading P first data blocks, and P is a positive integer;
performing a read operation based on the second read request, to obtain Q second data blocks, wherein one of the Q second data blocks is obtained by performing merge compression on at least one first data block, and the P first data blocks are a part or all of first data blocks for obtaining the Q second data blocks; and
obtaining the P first data blocks based on data obtained by decompressing the Q second data blocks.

2. The method according to claim 1, wherein before obtaining the second read request, the method further comprises:
receiving first signaling from a client, wherein the first signaling is for requesting to obtain a third data block;
determining the P first data blocks based on the first signaling, wherein the P first data blocks are data blocks associated with the third data block; and
determining the P first read requests based on the P first data blocks.

3. The method according to claim 2, wherein the method further comprises:
storing the P first data blocks in a memory;
receiving second signaling from the client, wherein the second signaling is for requesting to obtain a fourth data block, and the fourth data block comprises a part or all of the P first data blocks; and
obtaining the fourth data block from the memory, and sending the fourth data block to the client.

4. The method according to any one of claims 1 to 3, wherein first identifiers of the P first data blocks are consecutive, and each first identifier identifies one first data block.

5. The method according to claim 4, wherein that the first identifiers of the P first data blocks are consecutive comprises:
storage addresses of the P first data blocks are consecutive; and/or
sequence numbers of the P first data blocks in a file are consecutive, the file comprises the P first data blocks, and the sequence number indicates a location of one first data block in the file.

6. The method according to any one of claims 1 to 5, wherein the obtaining a second read request comprises:
obtaining second identifiers of the P first data blocks based on the first identifiers comprised in the P first read requests, wherein each first identifier identifies one first data block, and a second identifier of one of the P first data blocks indicates a location of the first data block; and
merging the P first read requests based on the second identifiers of the P first data blocks, to obtain the second read request.

7. The method according to claim 6, wherein the second identifier of the first data block comprises one or more of the following:
a third identifier, indicating a storage unit in which a second data block to which the first data block belongs is located;
first information, indicating a location of the second data block to which the first data block belongs in the storage unit; or
second information, indicating a location of the first data block in a fifth data block to which the first data block belongs, wherein the fifth data block is obtained by decompressing the second data block to which the first data block belongs.

8. The method according to any one of claims 1 to 7, wherein the method further comprises:
obtaining N first data blocks, wherein first identifiers of the N first data blocks are consecutive, each of the first identifiers identifies one first data block, and N is a positive integer;
performing merge compression on the N first data blocks based on the first identifiers of the N first data blocks, to obtain a second data block; and
storing the second data block in a first storage unit.

9. A data write method, wherein the method comprises:
obtaining N first data blocks, wherein first identifiers of the N first data blocks are consecutive, one of the first identifiers identifies one first data block, and N is a positive integer;
performing merge compression on the N first data blocks based on the first identifiers of the N first data blocks, to obtain a second data block; and
storing the second data block in a first storage unit.

10. The method according to claim 9, wherein the first identifier comprises:
a storage address of the first data block; and/or
a sequence number of the first data block in a file, wherein the file comprises the N first data blocks, and the sequence number of the first data block in the file indicates a location of the first data block in the file.

11. The method according to claim 9 or 10, wherein the obtaining N first data blocks comprises:
receiving at least one data packet from a client, wherein each of the at least one data packet comprises one or more sixth data blocks, and first identifiers of the one or more sixth data blocks are consecutive;
storing, in a memory, the one or more sixth data blocks comprised in each of the at least one data packet;
aggregating a plurality of sixth data blocks stored in the memory, to obtain at least one seventh data block; and
slicing the at least one seventh data block to obtain the N first data blocks.

12. The method according to any one of claims 9 to 11, wherein the performing merge compression on the N first data blocks based on the first identifiers of the N first data blocks, to obtain a second data block comprises:
concatenating the N first data blocks in a sequence of the first identifiers of the N first data blocks, to obtain a fifth data block; and
compressing the fifth data block to obtain the second data block.

13. The method according to any one of claims 9 to 12, wherein after the storing the second data block in a first storage unit, the method further comprises:
storing second identifiers of the N first data blocks, wherein each second identifier indicates a location of one first data block; and
a second identifier of one of the N first data blocks comprises one or more of the following:
a third identifier, indicating the storage unit in which the second data block to which the first data block belongs is located;
first information, indicating a location of the second data block to which the first data block belongs in the first storage unit; and
second information, indicating a location of the first data block in the fifth data block to which the first data block belongs.

14. The method according to any one of claims 9 to 13, wherein the method further comprises:
determining that a value of a first parameter of a second storage unit is greater than a third threshold, wherein the first parameter indicates a quantity of invalid first data blocks stored in the second storage unit, and the invalid first data block is a data block that is indicated by a corresponding first identifier and whose data is rewritten or deleted; and
releasing the second storage unit.

15. The method according to any one of claims 9 to 14, wherein the method further comprises:
determining a second read request, wherein the second read request is determined based on P first read requests, the P first read requests are for reading P first data blocks, and P is a positive integer;
performing a read operation based on the second read request, to obtain Q second data blocks, wherein one of the Q second data blocks is obtained by performing merge compression on at least one first data block, and the P first data blocks are a part or all of first data blocks for obtaining the Q second data blocks; and
obtaining the P first data blocks based on data obtained by decompressing the Q second data blocks.

16. A data processing apparatus, wherein the data processing apparatus comprises a processing unit and a transceiver unit, and the processing unit is coupled to the transceiver unit, to perform the method according to any one of claims 1 to 8, or perform the method according to any one of claims 9 to 15.

17. A computer program product, wherein the computer program product comprises a computer program, and when the computer program is run on a computer, the computer is enabled to perform the method according to any one of claims 1 to 8, or the computer is enabled to perform the method according to any one of claims 9 to 15.
